(19) Europäisches Patentamt
European Patent Office
Office européen des brevets

(11) **EP 3 931 675 B1**

(12) **EUROPEAN PATENT SPECIFICATION**

(45) Date of publication and mention
of the grant of the patent:
**11.01.2023 Bulletin 2023/02**

(21) Application number: **20718653.7**

(22) Date of filing: **09.04.2020**

(51) International Patent Classification (IPC):
*G06F 3/0481* (2022.01)   *G06F 3/0484* (2022.01)
*G06F 3/04815* (2022.01)   *G06F 3/04845* (2022.01)
*G06F 30/12* (2020.01)   *G06T 11/20* (2006.01)
*G06F 3/04883* (2022.01)

(52) Cooperative Patent Classification (CPC):
**G06F 3/04815; G06F 3/04845; G06F 3/04883;**
**G06F 30/12; G06T 11/203;** G06F 2203/04802;
G06T 2200/24

(86) International application number:
**PCT/EP2020/060280**

(87) International publication number:
**WO 2020/208204 (15.10.2020 Gazette 2020/42)**

(54) **TOOL AND METHOD FOR DRAWING 3-D CURVES IN 2-D**

WERKZEUG UND VERFAHREN ZUM ZEICHNEN VON 3D-KURVEN IN 2D

OUTIL ET PROCÉDÉ POUR DESSINER DES COURBES 3D EN 2-D

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **11.04.2019 GB 201905165**

(43) Date of publication of application:
**05.01.2022 Bulletin 2022/01**

(73) Proprietor: **Goggle Collective Ltd.**
**Guildford, Surrey GU1 3UW (GB)**

(72) Inventor: **JOHNSTON, Neil**
**Guildford Surrey GU1 3UW (GB)**

(74) Representative: **Dunlop, Hugh Christopher et al**
**Maucher Jenkins**
**Seventh Floor Offices**
**Artillery House**
**11-19 Artillery Row**
**London SW1P 1RT (GB)**

(56) References cited:
**EP-A1- 0 686 281**       **WO-A1-2018/075054**
**US-A1- 2012 206 419**   **US-B1- 9 147 282**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the Invention

This invention relates to drawing tools, for example to assist in the drawing and design of motor cars and other vehicles, but generally for computer-aided design of three dimensional objects in a two dimensional drawing environment.

### Background

When drawing in three dimensions (3D), most CAD tools require that a particular two dimensional (2D) plane is selected, and features are projected onto that plane. Editing can be performed in the selected plane or perpendicular to it. For example, control points of a line can be moved in the selected plane or perpendicular to it. If a curved line is edited in this way, it is often necessary to select different views to fully visualize the effect of a change.

In the field of automotive design and nautical and aeronautical design, there is an increasing need to be able to generate and edit 3D representations of vehicles, aircraft and the like with straight lines and smooth curves, in particular aerodynamic or hydrodynamic curves. This needs to be achieved with speed and ease of use and deliver a result with minimum of editing.

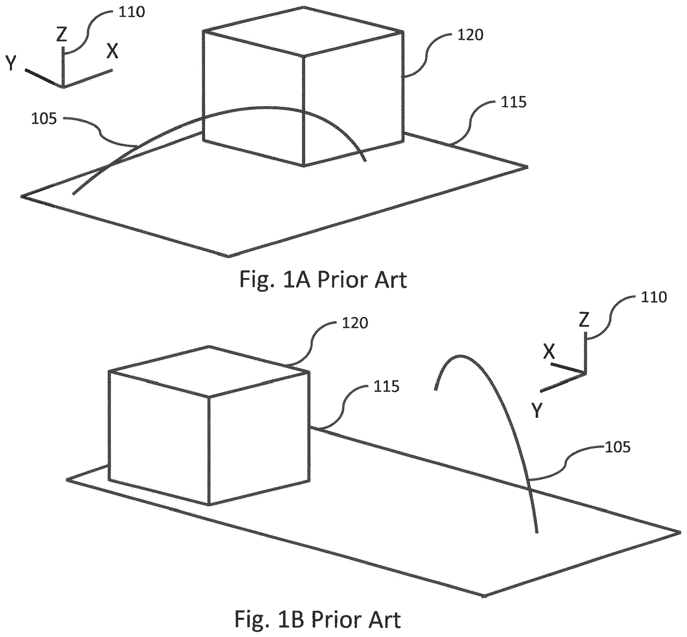

The use of interactive screens is of growing importance to many design-based industries. Typically, a user will make use of an interactive screen and a cursor or stylus to access tools in a 2D projection of 3D objects. The tools are then used to create and edit representations of the 3D objects in the 2D projection. Fig. 1 (prior art) shows a curve drawn using an existing CAD tool. Fig. 1A shows a user's perspective view of a 3D objects (plane 115, cube 120) in coordinate system 110. Coordinate system 110 is shown with three perpendicular axes X, Y and Z. Fig. 1A shows a curve 105 drawn from a user's perspective view apparently starting and ending at the desired points on plane 115. Fig. 1B shows the same curve from a different perspective view (note the 3D objects have been rotated, as is apparent from the coordinate system 110) and shows that the start/end point(s) of the curve 105 are in/not in intended the positions.

There is scope for improving the ease-of-use of CAD tools for drawing 3D objects in 2D, particularly for drawing of objects having smooth continuous, graceful curves, such as vehicles, aeroplanes, boats, etc. that have aerodynamic or streamlined qualities.

US 2012/206419 A1 (LEE JINHA [US] ET AL) 16 August 2012, relates to input and interaction technologies. EP 0 686 281 A1 (INTERGRAPH CORP [US]) 13 December 1995, relates to providing input data for 3D CAD systems. US 9 147 282 B1 (COTE STEPHANE [CA] ET AL) 29 September 2015, relates to techniques for manipulating a virtual tool in 3-D space with a pointing device that only captures motion in two-dimensions. WO 2018/075054 A1 (HEWLETT PACKARD DEVELOPMENT CO [US]) 26 April 2018, relates to a "CAD drawing [that] is used to create 3D objects within a 3D space" in which "a user may execute a CAD program on a computing device that receives input from an input device and translates that input onto a two-dimensional (2D) screen.

### Summary of the Invention

The invention is defined by the independent claims. Preferred embodiments are disclosed in the dependent claims.

### Brief description of the drawings

Figs. 1A and 1B are perspective view of a curve drawn in the perspective view of Fig. 1A using a prior art method.
Fig. 2 shows the coordinate system of an interactive screen (x, y) and the coordinate system of a 3D object (X, Y, Z) displayed on the interactive screen.
Fig. 3 is a high level flow diagram for drawing a curve.
Fig. 4 is an example screenshot of a curve about to be drawn in a perspective view.
Fig. 5 is an example screenshot of a curve being completed in a perspective view.
Fig. 6 is an example screenshot showing the completed curve in a perspective view.
Fig. 7 is an example screenshot showing the completed curve and its control points in a perspective view.
Fig. 8 is an example screenshot showing the completed curve and its control points in a perspective view.
Figs. 9A and 9B is a perspective and a plan view schematic of drawing a curve on an object.
Fig. 10 is a process flow diagram showing the process for drawing a curve.
Fig. 11 is a process flow diagram showing the feature identification sub-routine of Fig. 10.
Fig. 12 is a diagram of a curve comprising B-splines.

## Detailed description

The following description includes specific details for the purpose of providing an understanding of various concepts, but it will be apparent to those skilled in the art that these concepts may be practiced without these specific details. The following description is not intended to represent the only configurations in which the concepts described herein may be practiced.

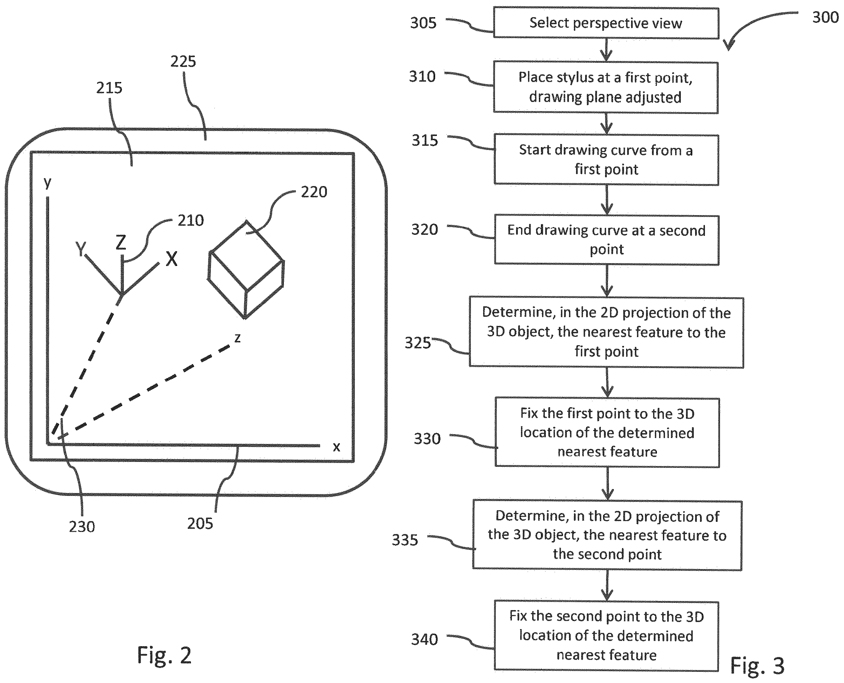

Fig. 2 is a diagram showing a first coordinate system 205 with two perpendicular axes, x and y, representing the coordinates of a screen 215 of a device 225. The screen 215 is a 2D surface, so only two coordinates (x, y) are required to identify a location on the screen 215. The third coordinate axis, z, perpendicular to the x and y axes of the first coordinate system 205 is represented as a dotted line. The first co-ordinate system 205 may be referred to as a "camera" coordinate system.

A 3D object 220 is rendered for display in 2D at a perspective view on the screen 215. A second coordinate system 210 is shown, with three perpendicular axes X, Y and Z. The second coordinate system 210 is a coordinate system associated with the object 220. A vector 230 is shown from the origin of the first coordinate system to the origin of the second coordinate system. For present purposes, the vector will be referred to as $(x_0, y_0, z_0)$ in the first co-ordinate system (but could be referenced in the second coordinate system).

The second coordinate system 210 can be translated, rotated, and the level of zoom may be changed. Thus, the object 220 may be translated, rotated, and the view zoomed in order to view the object 220 from different perspectives. When translated, the vector $(x_0, y_0)$ changes. When zooming, the vector $(z_0)$ changes - i.e. the object grows or shrinks giving the appearance of coming closer to the viewer (in the z axis) or moving further away.

The second coordinate system 210 is shown rotated relative to the first coordinate system 205 to provide a perspective view of the 3D object. Rotation around the X axis is referred to as "roll". Rotation around the Y axis is referred to as "yaw". Rotation around the Z axis is referred to as "pitch". When rotating, respective angles $\alpha$, $\beta$, $\gamma$ (not shown) between axes X and x, axes Y and y and axes Z and z will change. When rotated in the second co-ordinate system to give a new perspective on the second coordinate system, a re-calculation is conducted by the rendering program to convert every point in the second co-ordinate system to an (x, y) point on the screen (with a z coordinate in the background).

Every feature on the object is rendered as pixels in the x-y plane of the screen and, conversely, every pixel on the x-y plane of the screen corresponds to a point in 3D space in the XYZ co-ordinate system.

Any location (x, y) on the screen 215 has a plurality of possible depth locations along the z axis. There is a need for disambiguating the z, or "depth", at which a point is placed on the screen 215 in a perspective view in order to correctly position the point in the second (3D) coordinate system 210.

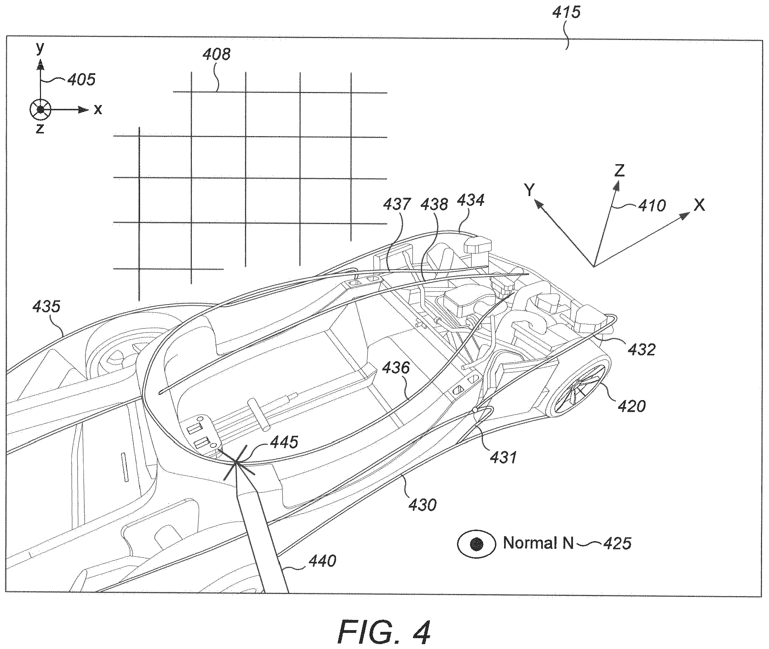

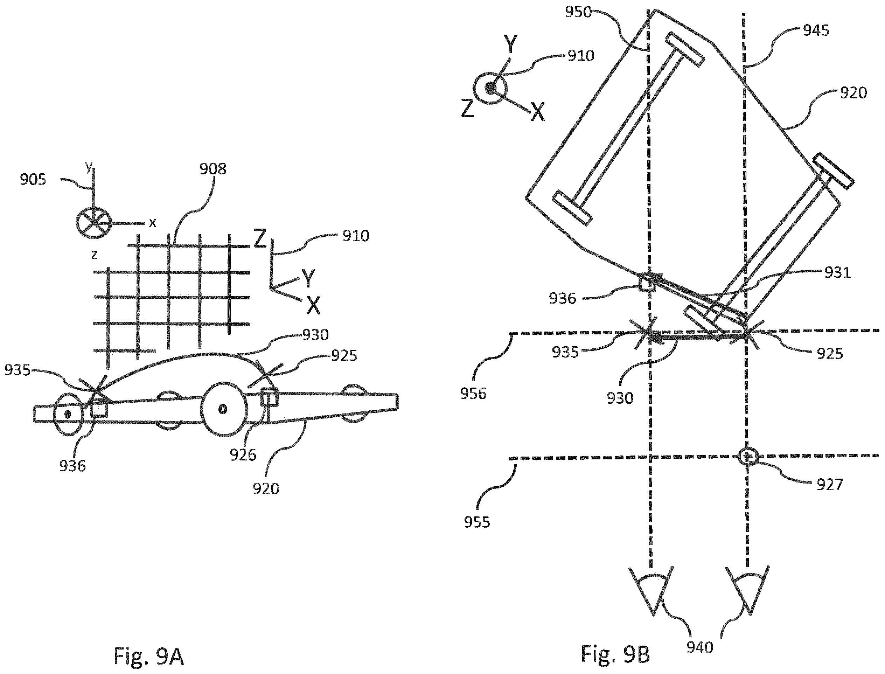

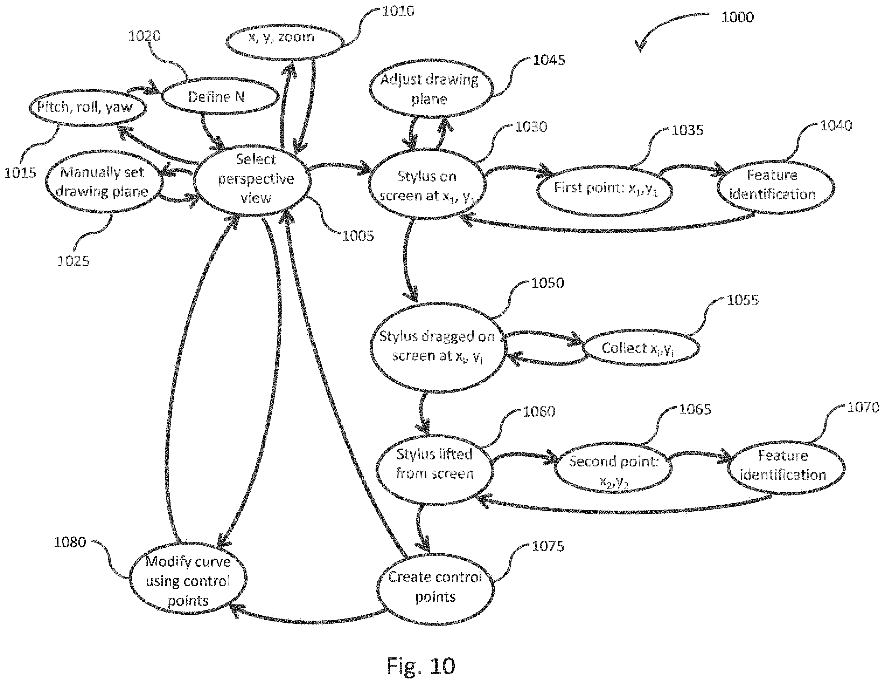

Fig. 3 is a high level flow diagram of a method 300 for drawing a line or curve on a screen 215 in a first coordinate system 205 and determining the appropriate positioning for the line or curve in the second coordinate system 210. Fig. 3 will be described with reference to the curve 450 drawn in Figs. 4-8, the curve 930 drawn in Figs. 9A and 9B, and is shown in more detail in the bubble diagram of Fig. 10.

Figs. 4-8 show the process of drawing a curve on a screen and positioning said curve in the second coordinate system 210. Figs. 4-8 each show a screen 415 having a first coordinate system 405. An object 420 is a 3D object rendered in 2D on the screen 415. First coordinate system 405, second coordinate system 410, screen 415, and object 420 may be regarded as equivalent to the first coordinate system 205, second coordinate system 210, screen 215, and object 220, respectively, described with reference to Fig. 2.

In Figs. 4-8, the object 420 is shown as a vehicle chassis but may be any other 3D object. The vehicle may be a car, aeroplane, boat, spacecraft or the like. The object may be a building, domestic appliance, consumer product or the like. The object 420 is associated with a second coordinate system 410. The second coordinate system 410 is rotated, translated, and zoomed to provide a perspective view of the 3D object 420 as described with reference to Fig. 2. As can be appreciated from Fig. 4, any given (x, y) location on the rendered object 420, and therefore on the screen 415, can be associated with multiple locations in the depth direction, perpendicular to the plane of the screen. A normal, $N_1$, 425 is identified as perpendicular to the plane of the screen. The normal 425 may be considered as parallel to the z-axis.

A part of a drawing plane 408 is shown. It is represented as a feint grid of lines parallel to the x and y axes that create grid squares, representing a plane at a selectable depth in the z dimension. The drawing plane can be at the camera depth (z=0) or below the camera depth. As the drawing plane is moved deeper, the size of the grid squares diminishes. As it is brought closer, the size of the grid squares increases. The drawing plane can be represented as a transparent plane with all features of the object 420 visible through the plane, or as a solid plane, with features below the plane hidden from view. (For simplicity of illustration and so as not to clutter the diagram unnecessarily, only part of the drawing plane is illustrated.)

Figs. 4-8 show the 3D object 420 (e.g. a chassis of a vehicle) and shows a plurality of pre-existing curves 430-438 over and around the chassis. Together, the 3D object and the pre-existing curves represent "features" which will be referred to, some of the pre-existing curves may be mirror images of others across a plane of symmetry. For example, curve 437 is a mirror image of curve 436 across a plane of symmetry parallel to a plane defined by the X-Z

EP 3 931 675 B1

axes positioned at the centre of the object 420. The pre-existing curves 430-438 have locations in the 3D space of the second coordinate system 410 and are rendered for view in the first coordinate system 405. The pre-existing curves 430-438 may have been drawn by the method described herein.

Method 300 begins at 305 by the selection of a perspective view. A user may select the perspective view as the most convenient from which to draw the desired curve. The selected perspective view will likely enable the user to view the start and end points of the curve that they wish to draw. Fig. 4 shows a perspective view of the 3D object 420 rendered in 2D on screen 415. Having set the perspective view, the user can (optionally) set the depth of the drawing plane 408.

At 310 the user may create a start point in the first coordinate system 405 on the screen 415. The screen 415 is an interactive screen and the user interacts with the screen using a stylus 440. Placing a tip of the stylus 440 on the screen 415 results in creation of the first point 445.

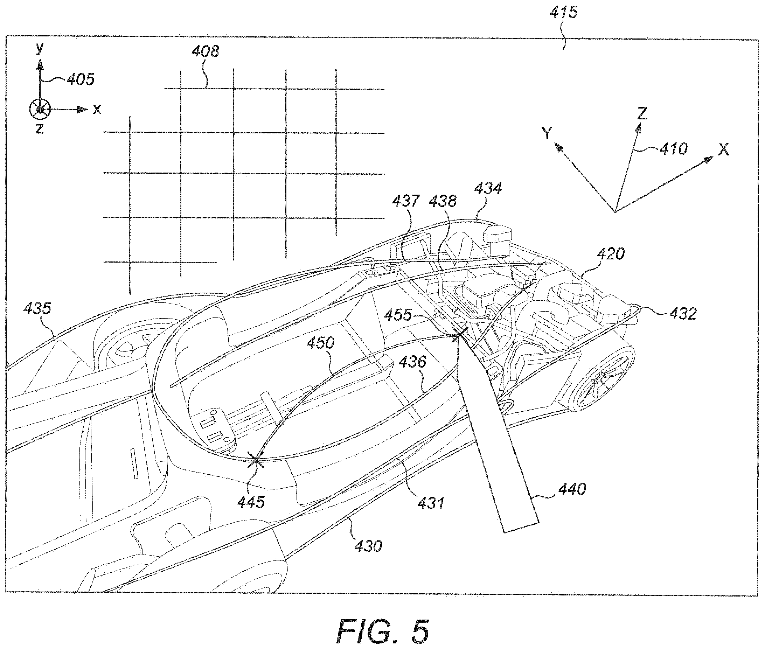

At steps 315 and 320 of Fig. 3, a curve 450 is drawn from the first point 445 to a second point 455, as shown in Fig. 5. The curve 450 is drawn by dragging the tip of the stylus 440 across the screen 415. The "depth" at which the first point 445, second point 455, and curve 450 are intended to be positioned is ambiguous based on their locations in the first coordinate system.

In an example, placing a tip of the stylus 440 on the screen in the first coordinate system 405 results in the depth of the drawing plane 408 being adjusted. The adjustment is effected by identifying a feature of the object 420 that corresponds to the position where the tip of the stylus is placed and calculating, in the first co-ordinate system, the z dimension (depth) of that feature. The drawing plane is then adjusted ("snapped") to that depth. The scale of the drawing plane grid is adjusted accordingly.

The feature of the object 420 that corresponds to the position where the tip of the stylus is placed is identified by image recognition techniques. At the (x, y) position of the stylus, the rendering software is rendering the image of the object. By examining the grey-scale contrast (or colour contrast), image recognition processing can identify that there is a contrast such as a line or an edge or other feature. Such a feature is represented in the second co-ordinate system because, as has been explained, every pixel on the x-y plane of the screen corresponds to a point in 3D space in the XYZ coordinate system. Where there is more than one feature at that position (e.g. because the object is transparent), the uppermost feature (from the viewer's perspective) is selected - i.e. the feature at the least depth in the z dimension.

In this way, the (x,y) location of the tip of the stylus 440 is matched to a first depth in the first coordinate system 405. The drawing plane 408 in the first coordinate system 405, parallel to the plane of the screen 415, is (preferably) moved to that depth.

At step 325 (Fig. 3) the feature nearest to the first point 445, as seen from the perspective view is determined. A feature may be a surface or line on object 420 or one of the pre-existing curves to 430-438. In the illustrated example, pre-existing curve 436 is identified as the feature upon which the first point 445 is to be located.

At step 330, the first point 445 is fixed ("snapped") to the position of the identified feature in the second coordinate system 410 and identified as the start point 446. Thus, the start point 446 is given a position in the 3D coordinate system of the object 420 and the "depth" of the first point 445 in the perspective view is disambiguated.

At step 335 the feature nearest to the second point 455, as seen from the perspective view is determined. A feature may be a surface or line on object 420 or one of the pre-existing curves to 430-438. In the illustrated example, pre-existing curve 436 is identified as the feature upon which the second point 455 is to be located.

At step 340, the second point 455 is fixed to the position of the feature in the second coordinate system 410 and identified as the end point 456. Thus, the end point 456 is given a position in the 3D coordinate system of the object 420 and the "depth" of the second point 455 in the perspective view is disambiguated. The first point is subject to a vector translation from the first point location in the 2D coordinate system to the start point in the 3D coordinate system (fixed/snapped to an existing feature). The second point is likewise subject to a vector translation from the second point location in the 2D coordinate system to the end point in the 3D coordinate system (fixed/snapped to an existing feature). Each sample point between the first and second points (i.e. each location on the drawn line between the first and second points) is subject to a vector translation which is an interpolation between the first and second points along the curve. This forms the curve in the 3D coordinate system. In other words, the first point is subject to a first vector translation from the first point in the first, 2D, coordinate system to the captured start point in the second, 3D, coordinate system, the second point is subject to a second vector translation from the second point in the first, 2D, coordinate system to the captured end point in the second, 3D, coordinate system, the curve in the first, 2D, coordinate system is represented by sample points between the first and second points, and interpolated translations of the sample points from the first, 2D, coordinate system to the second, 3D, coordinate system, each interpolated vector translation comprising an interpolation, for the respective sample point, between the first vector translation and the second vector translation. The plane in which the curve lies (in the 3D coordinate system) is defined by a 3D vector between the start point and the end point of the curve and a line perpendicular to that 3D vector which is parallel to the plane (that of the screen or a pre-set plane - see later) on which the curve was drawn.

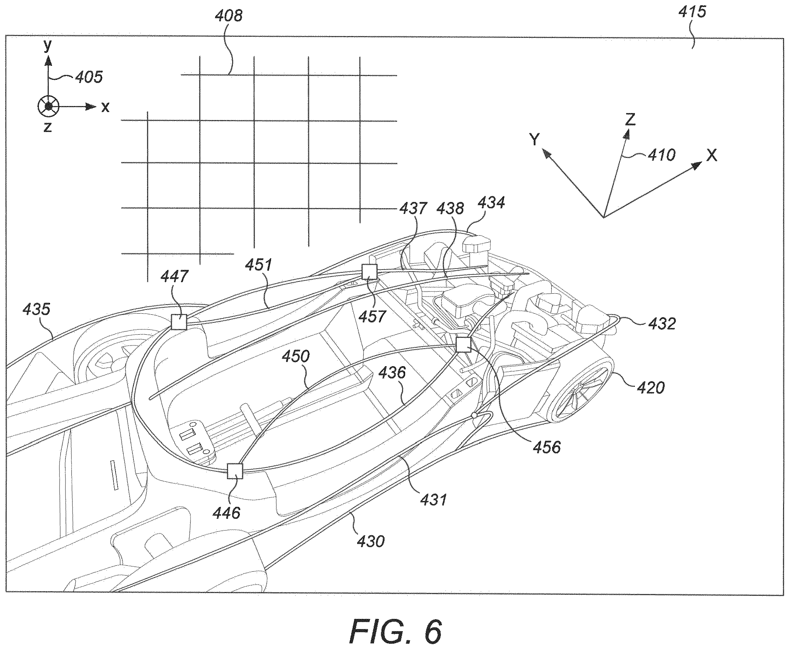

As can be seen from Figs. 6-8, the start point 446 and end point 456 have been located as coinciding with the pre-existing curve 436.

Mirror image locations of the points and lines may also be created as first mirror point, second mirror point, and mirror start point 447, mirror end point 457, and mirror curve 451, as shown in Figs. 6-8. These mirror points and curve are generated by a plane of symmetry lying parallel to the X-Z plane and intersecting the centre of object 420.

As an alternative to fixing a start or end point to a feature identified within the rendered image of the object, 420, the start point can be set to begin on the drawing plane or the end point can be set to be on the drawing plane. These options are selected by the user. Thus, for example, the user can select (using a menu, not shown) an option to begin a line on the drawing plane and end on a feature of the object, or the user can set the drawing plane to a desired destination depth (before placing the stylus at the start point) and then draw the line from a feature identified by the software as a start point and draw to the destination, at which the end point depth is selected to be the depth of the drawing plane. To set the drawing plane depth, the user is presented with a suitable scroll-bar or other depth setting interactive graphical user interface control. By adjusting the control, the drawing plane is seen to rise or fall to the desired depth. Then, when set, the user can draw the line from a desired feature to a point on that drawing plane.

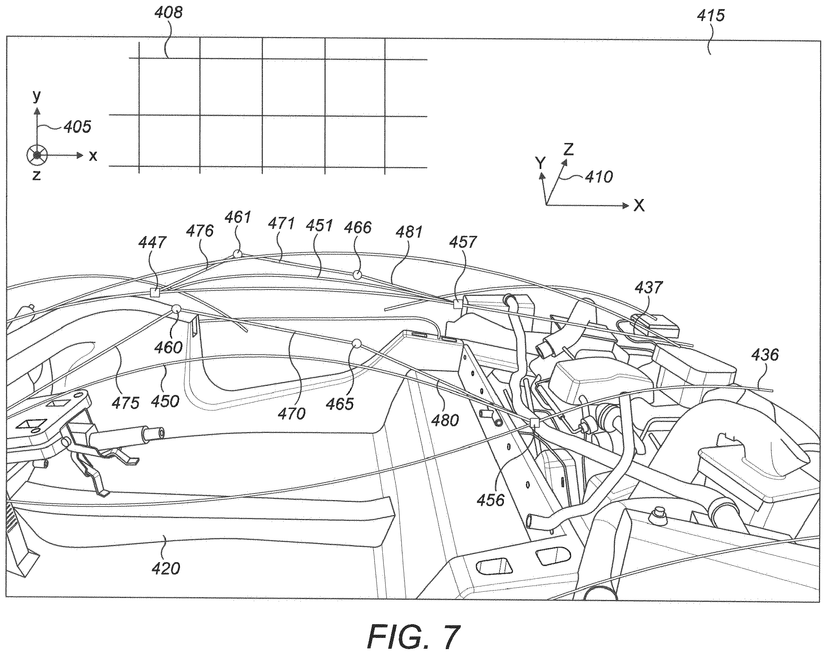

Fig. 7 shows a zoomed view of the curve 450 and the mirror curve 451. Control points 460 and 465 are generated, joined together by a straight line 470 and connected to the start point 446 and end point 456 of the curve 450 by straight lines 475 and 480. In the example, it may be noted that the controls points 460 and 465 are not on the curve 450 being controlled by the control points. Rather, they represent points on tangents to the curve at the start and end points of the curve, and/or points on connecting lines connecting those tangents. (In an alternative example, the control points are intermediate points on the curve itself.) It should also be noted that the start point 446 and end point 456 of the curve 450 are both also control points.

As curve 450 is generated, a mirror curve 451 is also created. The mirror curve 451 is formed by reflecting the line 450 in a virtual mirror. The control points 460 and 465 also have associated mirror control points 461 and 466, joined together by a mirror straight line 471 and connected to the mirror start point 447 and mirror end point 457 of the mirror curve 451 by straight lines 476 and 481.

The control points can be used to manipulate the curve 450 and mirror curve 451. Curves 450 and 451 may be manipulated separately or in unison. Manipulation using control points is described later.

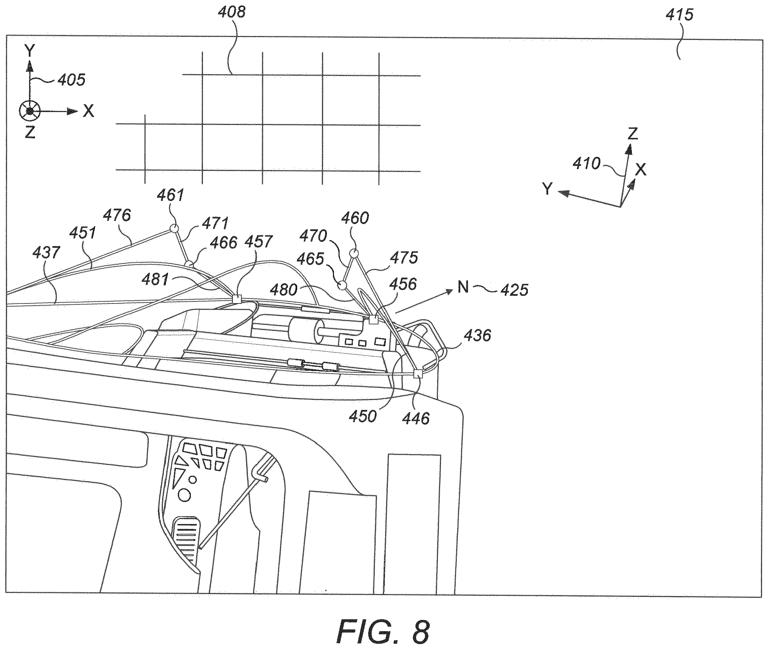

Fig. 8 shows the object 420 and curves 450 and 451 from a second perspective view. Although the perspective has changed, the drawing plane 408 is still parallel to the viewing plane. It can be seen from this perspective that the curve 450 that has been drawn lies in a flat plane (although this need not necessarily be the case). The plane in which the curve 450 lies is defined by a 3D vector between the start point 446 and end point 456 of the curve 450 and a line perpendicular to that 3D vector which is parallel to the plane of the screen (or the drawing plane, for examples in which a drawing plane is selected) on which the curve 450 was drawn. The normal, $N_1$, 425 to the plane of the curve 450 is indicated. Thus, the curve 450 has an angle relative to the second coordinate system 410. Moving the control points 460 and 465 perpendicular to the plane has the effect of moving the curve 450 out of the plane. If the control points 460 and 465 are not moved in unison, this can result in the curve 450 no longer resting in a flat plane.

The fixing of the start point 446 or end point 456 to positions in the second coordinate system in steps 430 and 440, respectively, comprises the identifying an object feature which is near to, or intersects, a normal to the plane of the screen 415. The object feature may be an object line or object surface.

If the object feature is a line, for example curve 436, then the fixing a point preferably comprises snapping the point to the line 436. This enables determination of the position in the second coordinate system 410 of the point.

Snapping of the end point 456 of curve 450 is illustrated in Figs. 5 and 6. In Fig. 5 the second point 455 is created by lifting the stylus 440 from the screen 415. The second point 455 does not coincide with the pre-existing curve 436, however, the second point 455 is snapped to the pre-existing curve 436 and is displayed as the end point 456 in Fig. 6.

The snapping is subject to certain criteria, and further involves an adjustment in the x and/or y directions on the screen. The adjustment in x and y directions is limited to be less than a threshold distance (a pre-set tolerance). The threshold is the diameter or resolution of the stylus (e.g. in pixels) multiplied by a factor. The factor is a value between two and four. In an example, the resolution or diameter of the stylus is pre-set. In an example, the threshold distance is learnt by training such that the adjustment takes account of both the diameter of the stylus and the user's accuracy in its placing.

The drawing plane can be moved automatically such that the snapped point is on the drawing plane.

Object features are identified by a contrast between pixels displayed on the screen 415 in the perspective view. The object features may be curves or surfaces. In an example, a line is identified by a broadly linear boundary across which there is a change in contrast with surrounding pixels. The boundary may be blurred by the rendering of the line in the first coordinate system. The stylus is identified as being placed on the line by any of the diameter or resolution of the stylus covering any pixel of the line. Preferably, this includes any pixels covering the blurred area. This object recognition by pixel contrast may be combined with the snapping as described herein.

As can be seen from Figs. 4-8, when a 3D object is rendered for view in 2D, any curved surfaces are typically provided with graded shading. Further, a first and a second connected surface which do not lie in a plane are usually rendered with different shading on each. Features can be identified by the shading contrast between non-planar surfaces and shading contrast on curved surfaces. Identification of features in this way enables placement of start and/or end points of curves at appropriate positions on surfaces.

If no line or contrast is identified for a first and/or second point to fix to, but instead the point is in front of a surface (from the perspective view) then the first and/or second point fixes to the surface. The position of the surface is known in the second (3D) coordinate system 410. Thus, fixing the point to the surface allows the "depth" at which the first and/or second point is placed to be disambiguated and for the point to be given a position in the second coordinate system 410 (and is treated as a start point or an end point). In this case there is no x and y adjustment of the first and/or second point.

If no line, contrast, or surface is identified for a first and/or second point to fix to then the first and/or second point is treated as being positioned on the existing drawing plane 408. This allows the point to be fixed as a position in the second coordinate system 410 using the drawing plane to disambiguate the depth, and the point is treated as a start point or end point.

In the examples described with reference to Figs. 4-8 (and as described above), the drawing plane is a plane parallel to the plane of the screen 415 in which curves are drawn. In other words, the drawing plane lies parallel to the x-y plane of the first coordinate system. The drawing plane 408 is viewed by the user as a grid comprising squares. The size of the grid changes as the drawing plane is moved through to the perspective view presented the user. If the drawing plane moves closer to the user (i.e. towards the user in the selected perspective view) then the squares on the grid increase in size. Conversely, if the drawing plane moves further away from the user (i.e. away from the user in the selected perspective view) then the squares on the grid decrease in size. Thus, the drawing plane serves to indicate at what depth in the perspective view a newly positioned first and/or second point will be placed. The grid of the drawing plane is not shown in Figs. 4-8 for reasons of clarity.

Fig. 9A shows a second example of drawing a curve in a perspective view. Similar to Figs. 4-8, in Fig. 9A a 3D object 920 is rendered in 2D on a screen. The screen has a first coordinate system 905 associated with it, and the object 920 has a second coordinate system 910 associated with it. As above, the first coordinate system 905 is 2D and the depth (or z - coordinate) of any point located in the first coordinate system 905 is ambiguous. The depth of a point located in the first coordinate system 905 must be disambiguated in order to determine a position for the point in the second, 3D, coordinate system 910.

In Fig. 9A, a curve 930 has been drawn from a first point 925 to a second point 935 in the perspective view. As in Figs. 4-8, the first point, curve, and second point are drawn by placing, dragging, and lifting a stylus from the screen.

Fig. 9B shows the object 920 in a plan view. For simplicity, the Z axis of the second co-ordinate system lies parallel to the screen. The object is viewed from along the Z axis of the first coordinate system 910 and the screen is shown as a line 955. A viewing location 940 is indicated as the location from which the perspective view of Fig. 9A is seen. Sightlines 945 and 950 intersect the first point 925 and the second point 935, respectively. The sightlines 945 and 950 are indicated for illustration only. Fig. 9B further shows the curve 930, drawn in the perspective view of Fig. 9A, before its start and end points have been fixed.

Fig. 9B shows the effect of method step 310 in which a drawing plane 908 is adjusted based on the placing of the stylus on the screen. In this step the drawing plane 908 moves from a first plane 955 to a second plane 956 in response to the tip of the stylus being placed on the screen at 927. Both plane 955 and plane 956 are parallel to the screen and therefore also parallel to a plane formed by the x-y axes of the first coordinate system 905. When the stylus is first placed on the screen, it is effectively placed at point 927 which is in free space. It is recognised that, from the user's perspective view, the intended location of the first point is at point 925, because this is a feature on the object 920 which is at the x-y location of the stylus in the perspective view. This enables the z-coordinate or "depth" to be disambiguated as described above. The first point 925 is fixed to a location in the second coordinate system 910 as the start point 926.

Recognising the intended location of the first point as a feature on the object allows the drawing plane to be adjusted. The drawing plane is adjusted such that the start point 926 is on the second plane 956. The drawing plane remains parallel to the screen and a plane formed by the x-y axes of the first coordinate system 905.

In an example, the adjustment of the drawing plane to plane 956 is executed as soon as the stylus is located at point 927. The curve 930 is then drawn on the adjusted drawing plane 956. The second point 935 is also located on the adjusted drawing plane.

In an example, the second point 935 may remain on the adjusted drawing plane 956. For example, it may be selected to do so, or there may be no location on the object 920 identified to fix the second point 935 to. In this case, the depth of the second point 935 is disambiguated using the adjusted drawing plane 956 to fix the second point 935 to a location in the second coordinate system 910 as an end point of the curve 930.

In an example, the second point 935 may not remain on the adjusted drawing plane 956. As shown in Figs. 9A and 9B, the second point 935 is identified as coinciding with an object feature (in this case, a line forming the object 920) in the perspective view of Fig. 9A. The depth at which the second point 935 is intended to be drawn is disambiguated by fixing the position of the end point 936 on this object feature. The fixing proceeds as described herein with reference to Figs. 4-8 and results in the curve 931. In this case the curve 931 sits on a plane that is defined by the start point 926 and the end point 936, and is parallel to the Z axis of the second coordinate system 910. (In the perspective view in Fig. 9A the Z axis is parallel to the screen and the plane defined by the x-y axes of the first coordinate system 905). The plane in which the curve 931 lies is defined by a 3D vector between the start point 926 and end point 936 of the curve 931 and a line perpendicular to that 3D vector which is parallel to the plane of the screen (or the drawing plane, for examples in which a drawing plane is selected) on which the curve 930 was drawn.

**Fixed drawing plane**

In the examples described with reference to Figs. 4-9, the plane in which a curve is created is defined wholly or in part by the perspective view set by the user when the first point, curve, and second point are located on the screen. The perspective view having been set by translation and rotation of the second coordinate system 210, 410, 910 relative to the first coordinate system 205, 405, 905.

Optionally, the location and angle of the drawing plane 408 can be set manually prior to creation of the first point. The location and angle of the drawing plane are set by moving the drawing plane through and/or around an existing object to the desired location and by rotating the plane to a desired orientation. Alternatively or additionally, the object can be moved (dragged) through and rotated relative to the drawing plane.

Once the drawing plane is set, the perspective view is altered before drawing a curve. Thus, a curve can be drawn on a selected drawing plane from any perspective view. This is useful for drawing a curve down the side of an object which is mainly viewed from the front, in this example the drawing plane can be set to be along the side of the object and a perspective view, at which to draw the curve, can be set at a perspective showing the front and side partially.

The curve is drawn on the set drawing plane by positioning the tip of the stylus on the screen to create a first point, dragging the stylus across the screen to create a curve, and lifting the stylus to create a second point. The depth at which the first point, second point, and curve can be simply disambiguated by the knowledge that they lie on the set drawing plane, and the position in the second coordinate system of the start point and end point is fixed.

Feature recognition can be used in this example. If the start and/or end point is proximal to an object feature (an object line or a object surface) in a direction perpendicular to the set drawing plane, then the drawing plane containing the start point, curve, and end point may be moved such that the start and/or end point coincides with the object feature.

If the set drawing plane moves so that one of a start or an end point coincides with the object feature, then the drawing plane is translated in a direction perpendicular to its plane and the moved plane is parallel to the set plane.

If the set drawing plane moves so that both of the start and the end point coincides with object feature(s), then the drawing plane may both translate in a direction perpendicular to its plane and rotate. The moved plane is no longer parallel to the set plane.

Additionally or alternatively, the start and/or end point may also be snapped to a feature which coincides with the plane as described with reference to Figs. 4-8.

**Overall process flow diagram**

Fig. 10 is an overall process flow 1000 diagram. Process flow 1000 is a more detailed version of the method 300. Fig. 10 will be described with reference to Figs. 4-8 but could equally be described with reference to Figs. 2 and 9.

Process flow 1000 begins at 1005 by selection of a perspective view of an object on a screen, for example 3D object 420 on screen 415 described with reference to Figs. 4-8. The perspective view is also selected at 1015 by pitch, roll, and yaw movements (rotations) of the second coordinate axis 410 relative to the first coordinate axis 405. The normal, N, 425 is recalculated at 1020 after a change in the perspective view by rotation in 1015. In an example, the drawing plane is manually set at 1025. When the perspective view is selected, the position of the object in that view can be adjusted in process 1010 to move the object in x and y directions and by zooming in and out. Process 1015 can be returned and the perspective view can be re-adjusted, etc.

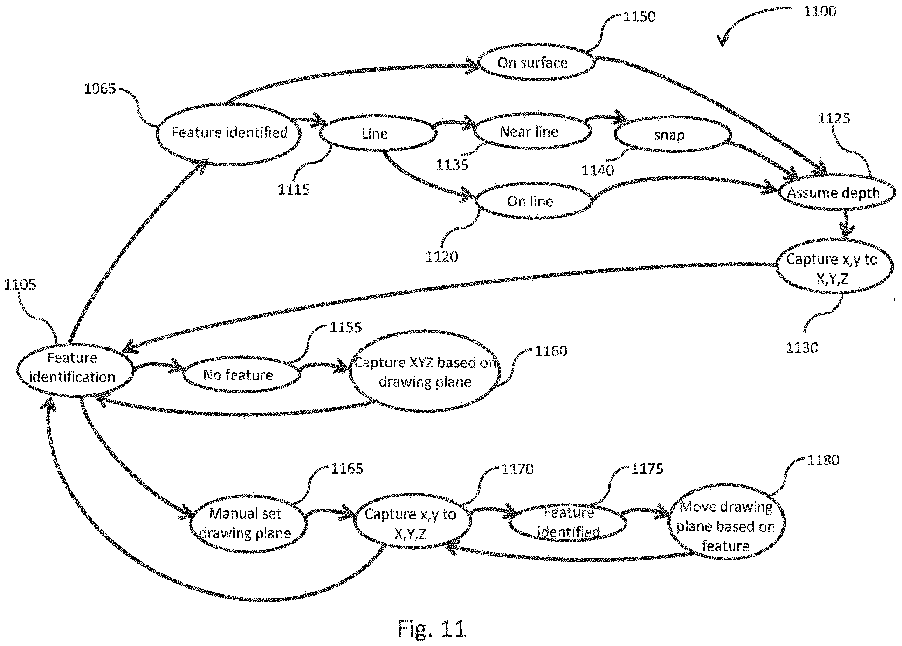

After selection of the perspective view at 1005 and the position of the object in that view, the process flow continues to 1030 when the tip of the stylus 440 is placed on the screen 415. At 1035, the location on the screen 415 at which the tip of the stylus 440 is placed is recorded as the first point 445 having coordinates $x_1, y_1$ in the first (2D) coordinate system 405. Feature identification is executed at 1040. Feature identification 1040 will be described in more detail with reference to Fig. 11. Feature identification at 1040 results in the first point 445 being fixed to a start point 446. The process flow returns to 1030 for the next movement of the stylus. Placing the stylus 440 on the screen 415 at 1030 may result in the location of the drawing plane being adjusted (process 1045) such that the drawing plane coincides with any features identified in feature identification 1040.

At 1050 the stylus 440 is dragged across the screen 415, the x and y positions of the stylus 440 are collected, as $x_i, y_i$, at 1055. The positions $x_i, y_i$ form the curve 450 on the screen 415.

7

At 1060 the stylus is lifted from the screen 415 and second point 455 is created at 1065. End feature identification may be executed at 1070. Feature identification 1070 is equivalent to feature identification 1040 and will be described in more detail with reference to Fig. 11. Feature identification at 1070 results in the second point 445 being fixed to an end point 446. The process flow returns to 1060 (or proceeds to 1075).

Next, at 1075, control points 460 and 465, and straight lines 470, 475, and 480 are generated.

It will be appreciated that a mirror curve comprising mirror first point, start point, second point, end point, control points, and straight lines may be generated along with the respective curve, first point, start point, second point, end point, control points, and straight lines at steps 1030-1075.

From 1075 the process may return to 1005 for the user to select a new perspective view. A new perspective view may be selected and the flow may continue to 1080 where the control points may be modified to change the shape, start position, and/or end position of the curve.

Alternatively, from 1075, the process flow continues to 1080 where the control points are modified. The process flow may then return to 1005 where a new perspective view may be selected.

Fig. 11 is a process flow diagram 1100 comprising the steps of feature identification. Process flow 1100 is a more detailed version of the feature identification 1040 and 1070 of Fig. 10.

Fig. 11 will be described with reference to the first point 445 of Figs. 4-8 but could equally be described with reference to the second point 455 of Figs. 4-8 or with reference to Figs. 2 and 9.

Process flow 1100 begins at 1105. If, at 1105, a feature of the 3D object is identified as being in the proximity of the x,y location of the first point then the process flow 1100 continues to 1110. A feature is in the proximity of the x,y location if the distance between the feature and the x,y location is less than a threshold. The threshold is a multiple, m, of the stylus resolution (or diameter). The multiple, m, may be 5.

At 1110 the identity of the feature is determined. If the feature is a curve 436 then the process flow continues to 1115. If the first point 445 is determined at 1120 to be on the curve 436 then at 1125 the depth is disambiguated using the position of the curve 436 in the second coordinate system 410. This enables, at 1130, the location x,y of the first point 445 on the screen 415 in the first coordinate system 401 to be captured to a position X,Y,Z in the second coordinate system 410, and identified as the start point 446. From 1130 the process flow returns to 1105 and continues in process flow 1000 of Fig. 10 as previously described.

If at step 1120 it is determined that the first point 445 is not on the identified curve 436, the process flow proceeds to 1135. At 1135, if the criteria for snapping the first point 445 to the curve 436 are met then the flow continues to 1140 where the first point 445 is snapped to the curve 436. The process flow continues to 1125 as described previously.

At 1135, if the criteria for snapping the first point 445 to the curve 436 are not met then the process flow continues to 1150 and the feature is identified as a surface. The position of the surface is used to disambiguate the depth of the first point and the process flow continues to 1125 as described previously.

Alternatively, at 1110 the feature may be directly identified as a surface, in which case the process flow 1100 proceeds to direct step 1150.

Referring again to 1105, if no feature is identified as relating to the first point 445 then the process flow proceeds to step 1155. At 1160 the position X,Y,Z in the second coordinate system 410 is captured based on the existing drawing plane. From 1160 the process flow returns to 1105 and continues in process flow 1000 of Fig. 10 as previously described.

Continuing to refer to 1105, if a drawing plane has been manually set, or fixed, prior to creation of the first point, then the process flow proceeds to 1165. At 1170, the location x,y of the first point in the first coordinate system 405 is fixed to a start point at a position X,Y,Z in the second coordinate system 410. The depth is disambiguated using the knowledge that the first point lies on the fixed drawing plane. From 1170 the process flow returns to 1105 and continues in process flow 1000 of Fig. 10 as previously described.

Optionally, at 1170 the process flow continues to 1175 if the start point (or end point) is identified as being proximal to an object feature in a direction perpendicular to the set drawing plane, then at 1180 the drawing plane is moved such that the start (and/or end point) coincides with the object feature. The process returns to 1170 where the position of the start point (and/or end point) is updated based on the moved drawing plane. From 1170 the process flow returns to 1105 and continues in process flow 1000 of Fig. 10 as previously described.

In the preceding examples, the screen is described as a touch screen which is interacted with using a stylus. A user can interact with the touch screen by positioning a finger on the touch screen. Optionally, a cursor, mouse, or pointer is used to interact with the screen. In the latter cases, the screen need not be a touch screen, but can be a computer screen or similar.

## Control points, splines, and curve fitting

The start point 446 and end point 456 of a curve 450 may be considered as control points. At step 1080 of process flow 1000, control points and curves may be manipulated, and curves and splines fitted as described in co-pending patent application PCT/EP2018/083618.

Control points 446, 456, 460, and 465 of the curve 450 are selected by positioning the stylus 440 on a control point in the perspective view. The shape and length of curve 450 can then subsequently be edited.

As a control point, for example control point 460, is selected and moved through space using the stylus 440, the shape and length of curve 450 changes depending on the new placement of the control point.

The mirror control point, for example control point 461 of mirror curve 451, simultaneously moves through space in the same manner and the shape and length of mirror line 451 also changes accordingly. The connecting straight lines 470, 475, and 480 and their corresponding mirror straight lines 471, 476, and 481 also move accordingly. The start point 446 and end point 456 of curve 450 do not move when control point 461 is moved, nor do the corresponding start point 447 and end point 457 of mirror curve 451.

If a curve (spline) or a control point is selected, then the mirror curve (spline) or control point is also selected. A user can edit a selected spline. The user may use the stylus to select the control point by positioning the stylus on the control point. Dragging the stylus across the screen causes the control point to be dragged in a path matching the movements of the stylus.

As the control point is being moved, the spline is recalculated to show the effect of the movements. The lines connecting the selected control point with other control points and/or line end points also move accordingly. The mirror version of the spline also updates accordingly. If the user is editing using a pre-set drawing plane in 2D, the control point will be locked to the selected drawing plane. If the user is drawing in 3D, the control point can be moved to any position, but the user must select an appropriate perspective view to do so, because the control point can only be moved in a plane parallel to the plane of view - i.e. in the x and y dimensions of the first co-ordinate system.

After selecting a spline, the user may decide to move the entire selected spline, rather than just a control point.

After selecting a spline, the user may decide to connect or hook it to a second spline. The nearest end of the first spline is hooked onto the nearest point of the second spline. The shape, position and control points of the second spline remain unchanged and so it acts as a parent spline in the new configuration. The appearance of the first spline and its dependencies is recalculated, since one of its control points has been moved. It acts as a child spline in the new configuration and can be moved along the parent spline without affecting the shape, position or control points of the parent spline.

After selecting a spline, the user may decide to attach the selected spline to a second spline. The user moves the stylus to align the stylus with a second spline and can use a trigger, to choose this second spline to attach the first spline to. The user uses the trigger and the first spline attaches to the second spline. The nearest end of the first spline is connected to the nearest point on the second spline. If the nearest point of the second spline is at one of its ends, the two splines share the same control point at their ends. If the nearest point of the second spline is somewhere along its length, the second spline is split at that point into two new splines. These two new splines, along with the first spline, all share the same control point at their ends. The appearance of the first spline and its dependencies are recalculated, since one of its control points has been moved.

After selecting a spline, the user can then add a control point. The user uses an "add control point" menu option and chooses a point at which to add a control point. A new control point is added to the spline at the point of the spline nearest to the point chosen by the user. The shape of the spline is unaffected. When a control point is added, existing control points may move according to the curve-fitting algorithm, so as to retain the shape of the curve despite it having one extra control point (because, for example, the sum-of-squares minimization results in a different solution when there is an extra control point). The user can then move and edit the spline as before.

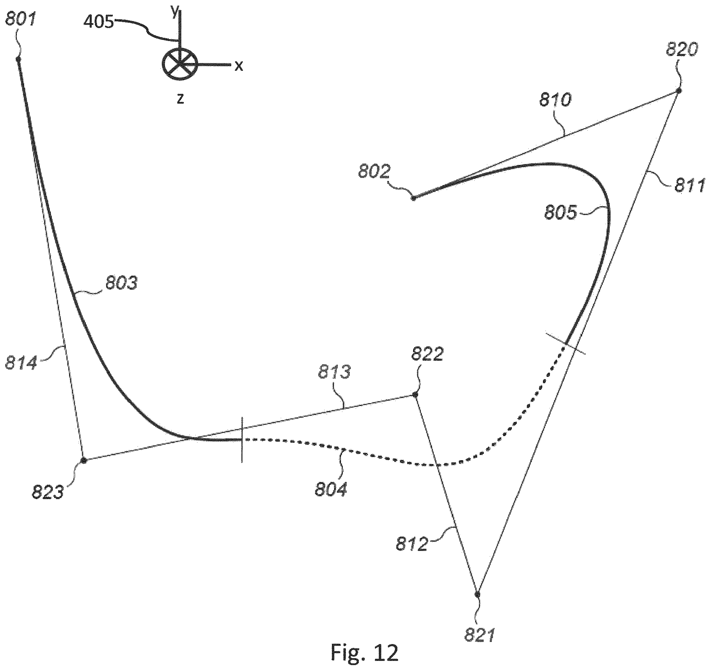

Referring now to Fig. 12, an example of a line represented as B-splines is shown. Curves 450 and 451 of Fig. are comprised of B-splines in the same way as the curve of Fig. 12. In this case, the line comprises three component curves (splines) 801, 802 and 803. The component curves join at positions ("knots") shown by dashed lines, but these are of no consequence to the user of the system. The ends of the component curves and the dashed lines are not visible. They are shown here for explanation only. Each component curve has the same continuity properties as its adjoining component curve (e.g. same gradient in each of two dimensions - i.e. in the plane of the image as shown and in a perpendicular plane tangential to the line at the joining knot). Hence, adjacent splines join each other at the knot, which is where the gradient of one spline matches the gradient of the adjacent spline. This is a constraint on the component curve function.

Each curve is defined by a polynomial function. For example, curve 805 may be a second or third order polynomial. Curve 803 may also be a portion of a second or third order polynomial. Curve 804 may be a third order polynomial (or may be a second order polynomial subject to a curving constraint at the end where it adjoins curve 803). Each component curve may comprise sub-components (splines), in which case, each subcomponent may be a lower order polynomial.

The control points are sampled from user input in real time, so the number of sample points is proportional (within the upper and lower bounds) to the length of the resultant spline (or, more particularly, proportional to the time taken for the user to draw the line). A slowly drawn line will be given more control points than a quickly drawn line, up to the maximum number of control points (e.g. 6).

Each inflexion causes an additional control point to be added, subject to the same maximum. (I.e. a quickly drawn line with one inflexion will have one control point more than a line drawn in the same time but with no inflexions.)

The knots are not constrained to uniform spacing along the line.

The second derivative of a second order B-spline need not be continuous at the knots.

The curve "fits" or is "fitted to" a polygon (an open polygon) comprising straight lines 810, 812, 813 and 814. The end sections of the polygon (lines 814 and 810) have the same gradient as the line at the respective end points. The fitting function is preferably a least-mean-squared fitting function, as will be explained.

As well as end control points 801 and 802, the curve has intermediate control points 820, 821, 822 and 823 at the corners of the polygon (the intersections between straight lines).

In the present system, a line is preferably provided with 2 or 3 mid control points. A small number of control points contributes to simple, efficient editing of smooth elegant curves, but lines may be provided with as many as 5 or 6 control points (i.e. one at each end and up to 3 or 4 in the middle). The number is preferably a system design option but could be presented to the user as a user option.

In the illustrated example, there is an inflexion in the curve - i.e. a reversal of gradient as the curve flows from section 803 to section 804. For this reason, in the 2D example of Fig. 8, line 813 crosses the curve (and line 812 crosses back again). (It may be noted, of course, that when the line of Fig. 8 is a 3D line, it is possible that the appearance of an inflexion is merely an illusion and that there are no inflexions and no "crossing" of the curve by the sides of the polygon.) Inflexions reflect the positioning of the control points. If a control point is moved, this may cause a new inflexion.

According to the fitting function, the straight lines of the polygon and their control points are selected such that the sum, for all incremental sections of the line, of distances between a point on the line and a corresponding point on the polygon, is minimized on a mean-squared basis.

For example, for a spline function of degree k, the fitting function seeks to minimize:

$$\sum_{\text{all } x}\left\{W(x)\left[y(x)-\sum_i \alpha_i B_{i,k,t}(x)\right]\right\}^2$$

where W(x) is a weight and y(x) is the datum value at x. The coefficients $\alpha i$ are the parameters to be determined. The knot values may be fixed or they too may be treated as parameters.

The above equation measures the squared distance between a sample point and its corresponding curve point. The error function measures the total accumulation of squared distances. The control points are recursively selected to make this error as small as possible. The number of sample points may be selected according to the computational capacity and the desired speed of calculation, but does not need to be high (e.g. 100 - 1000 sample points are typical).

The order of the spline function (which may be second order but is preferably no higher than third order) and the number of control points are limited to allow the calculations to converge on a single solution.

As the polygon is fitted to the line, so too is the line fitted to the polygon. This means that, once the control points are selected, they can be moved and the fitting function defines a new line to fit to the new polygon.

It is a great advantage of the arrangement described that the line has a smoothly curving function, which is particularly important in the design of vehicles, because the smoothly curving function will have good aerodynamic properties.

When two lines are joined, there is no smoothing of their functions at the join. When a first control point (which may be an end point) meets a second control point (which may be an end point of a mirror line to the first control point), the two associated lines merge into a single line. This can be automatic, in which case the lines behave as if one sticks to the other, or it can be user-driven by activation of a "join" button.

When two lines are joined, they retain their status as two lines. They cannot be manipulated together except in the very special case of when the two lines are actually one line and its mirror reflection. In this case, the two are moved together only because one is moved and it will cause its reflection to match its movements.

In cases where two lines are joined without being mirrors of each other, moving of one control point does not move "the whole line". The whole line can be selected and moved (translated, rotated or both).

The invention is not necessarily limited to shapes that are defined by spline functions. The system and methods described can be used with shapes defined by other functions. For example a circle (e.g. part of a wheel or an entire wheel) can be drawn in the second coordinate system either by free-drawing a circle or by drawing a radius (or a spoke) and causing the tool to display a circle/wheel of that radius.

In the case of a wheel, it can be presented with radius and thickness and with control points for each, whereby the user can select a radius control point and drag it inwards or outwards to reduce or expand the radius (with the movement of the control point constrained along a radial locus) or the user can select a width control point and expand or reduce the width of the wheel (with the movement of the control point constrained along an axial locus).

Circles and wheels can have the same selection, attaching, splitting and editing functions as have been described above for lines. In the case of splitting, for example, a function may be provided to divide a circle or wheel into sectors that retain their link to the original circle centre.

Similarly, a box frame can be drawn as a unit with control points for expanding or reducing in three dimensions and with the ability to join other lines to the box frame. In the case of joining a control point of a line to a control point of a box frame, movement of that control point will cause the line to change shape and cause the frame to change size, but the frame will maintain its box shape.

The tool provides functions that are specific to splines (drawing a freeform line, curvefitting it, editing control points) and functions that are more generic than splines (attaching one part of a model to another, mirroring, creating surfaces between edges, etc).

A closed loop of splines, for example four splines, can be selected. The user can then proceed with all four splines selected. A surface can be created using the four selected splines (or other number of splines forming a closed loop), using the connected splines as a perimeter. The surface appears as a smooth, contoured patch of material defined by the continuous loop of splines which form its perimeter.

A method and drawing tool has been described with reference to examples of operation and examples of lines and objects being drawn, but it will be understood by those in the art that these are non-limiting examples and that modifications of the apparatus, the method and the uses can be made without departing from the invention.

**Claims**

1. A method (300) for drawing a freehand curve (450, 931) on a 2D interactive screen (215, 415) in a first coordinate system (205, 405, 905), wherein a pointer (440) is used to interact with the screen (215, 415), the curve (450, 931) being represented in 3D space in a second , 3D, coordinate system (210, 410, 910), with a third dimension, which requires to be determined, wherein the curve (450, 931) is drawn on a 2D drawing plane (408, 908) positioned within the second, 3D, coordinate system (210, 410, 910), and wherein the drawing plane (408, 908) lies parallel to the plane of the interactive screen (215, 415), wherein the interactive screen (215, 415) is parallel to the x-y plane of the first coordinate system (205, 405, 905), the method comprising:

   selecting (305), for display on the interactive screen (215, 415), a perspective view of a 3D drawing object (220, 420, 920), the drawing object comprising features (220, 420, 430, 436, 920), wherein the orientation of the drawing plane (408, 908) is determined by selecting the perspective view;
   creating (310) a first point (445, 925) in the first coordinate system (205, 405, 905) on the interactive screen (215, 415);
   capturing (310, 325, 330) the first point (445, 925) in the second, 3D, coordinate system (210, 410, 910) as a start point (446, 926) for a curve (450, 931) being drawn in the drawing plane (408, 908), wherein the capturing of the first point (445, 925) as the start point (446, 926) comprises fixing the first point (445, 925) to a position that coincides with a feature (436, 920) of the drawing object which is nearest to the first point (445, 925) in the selected perspective view, wherein the feature is an edge, a surface, or a line of the drawing object, wherein the feature (436, 920) of the drawing object which is nearest to the first point being of known position in the second, 3D, coordinate system (210, 410, 910), whereby fixing causes the coordinates of the start point (446, 926) to be determined in the second, 3D, coordinate system, and wherein the drawing plane (408, 908) is adjusted to be at the depth of the feature (436, 920) of the drawing object (220, 420, 920) which is nearest to the first point (445, 925) in the selected perspective view;
   creating (320) a second point (455, 935) in the first coordinate system (205, 405, 905) on the interactive screen (215, 415);
   capturing (320, 335, 340) the second point (455, 935) in the second, 3D, coordinate system (210, 410, 910) as an end point (456, 936) for the curve (450, 931), wherein the capturing of the second point (455, 935) as the end point (456, 936) comprises fixing the second point (455, 935) to a position that coincides with a feature (436, 920) of the drawing object (220, 420, 920) which is nearest to the second point (455, 935) in the selected perspective view, wherein the feature is an edge, a surface, or a line of the drawing object, wherein the feature (436, 920) of the drawing object which is nearest to the second point being of known position in the second, 3D, coordinate system (210, 410, 910), whereby fixing causes the coordinates of the end point (456, 936) to be determined in the second, 3D, coordinate system.

2. A method (300) for drawing a freehand curve (450, 931) on a 2D interactive screen (215, 415) in a first coordinate system (205, 405, 905), wherein a pointer (440) is used to interact with the screen (215, 415), the curve (450, 931) being represented in 3D space in a second, 3D, coordinate system (210, 410, 910), with a third dimension, which requires to be determined, wherein the curve (450, 931) is drawn on a 2D drawing plane (408, 908) positioned within the second, 3D, coordinate system (210, 410, 910), and wherein the drawing plane (408, 908) lies parallel to the plane of the interactive screen (215, 415), wherein the interactive screen (215, 415) is parallel to the x-y plane of the first coordinate system (205, 405, 905), the method comprising:

selecting (305), for display on the interactive screen (215, 415), a perspective view of a 3D drawing object (220, 420, 920), the drawing object comprising features (220, 420, 430, 436, 920), wherein the orientation of the drawing plane (408, 908) is determined by selecting the perspective view;

creating (310) a first point (445, 925) in the first coordinate system (205, 405, 905) on the interactive screen (215, 415);

capturing (310, 325, 330) the first point (445, 925) in the second, 3D, coordinate system (210, 410, 910) as a start point (446, 926) for a curve (450, 931) being drawn in the drawing plane (408, 908), wherein the capturing of the first point (445, 925) as the start point (446, 926) comprises fixing the first point (445, 925) to a position that coincides with a feature (436, 920) of the drawing object which is nearest to the first point (445, 925) in the selected perspective view, wherein the feature is an edge, a surface, or a line of the drawing object, wherein the feature (436, 920) of the drawing object which is nearest to the first point being of known position in the second, 3D, coordinate system (210, 410, 910), whereby fixing causes the coordinates of the start point (446, 926) to be determined in the second, 3D, coordinate system, and wherein the drawing plane (408, 908) is adjusted to be at the depth of the feature (436, 920) of the drawing object (220, 420, 920) which is nearest to the first point (445, 925) in the selected perspective view;

creating (320) a second point (455, 935) in the first coordinate system (205, 405, 905) on the interactive screen (215, 415);

capturing (320, 335, 340) the second point (455, 935) in the second, 3D, coordinate system (210, 410, 910) as an end point (456, 936) for the curve (450, 931), wherein capturing of the second point (455, 935) as the end point (456, 936) comprises fixing the second point (455, 935) to the adjusted drawing plane (408, 908), whereby fixing causes the coordinates of the end point (456, 936) to be determined in the second, 3D, coordinate system.

3. The method of claim 1 or 2, wherein the drawing plane is a grid comprising squares which adjust in size to indicate the depth of the drawing plane.

4. The method of any preceding claim, wherein the pointer is a stylus having a set resolution.

5. The method of claim 4, wherein fixing comprises an x and y adjustment in the first coordinate system, the adjustment being less than the resolution of the stylus multiplied by a factor.

6. The method of claim 5, wherein the factor is a value between two and four.

7. The method of any preceding claim, further comprising:
dragging the pointer, from the first point to the second point, across the interactive screen to form the curve.

8. The method of claim 7, wherein the first point is created by placing the stylus on the surface of the interactive screen, the second point is created by lifting the stylus from the surface of the interactive screen.

9. The method of any preceding claim, wherein the curve lies in a plane defined by a vector between the start point and the end point in the second, 3D, coordinate system, and a line perpendicular to the vector which is parallel to the plane of the screen in which the curve was drawn.

10. A drawing tool for drawing a freehand curve (450, 931), the drawing tool comprising a 2D interactive screen (215, 415) and a pointer (440) to interact with the 2D interactive screen (215, 415), and the tool for drawing a freehand curve (450, 931) on the 2D interactive screen (215, 415) in a first coordinate system (205, 405, 905), the curve (450, 931) being represented in 3D space in a second, 3D, coordinate system (210, 410, 910), with a third dimension, which requires to be determined, wherein the curve (450, 931) is drawn on a 2D drawing plane (408, 908) positioned within the second, 3D, coordinate system (210, 410, 910), and wherein the drawing plane (408, 908) lies parallel to the plane of the interactive screen (215, 415), wherein the interactive screen (215, 415) is parallel to the x-y plane of the first coordinate system (205, 405, 905), the drawing tool further comprising:

means for selecting, for display on the interactive screen (215, 415), a perspective view of a 3D drawing object (220, 420, 920), the drawing object comprising features (220, 420, 430, 436, 920), wherein the orientation of the drawing plane (408, 908) is determined by selecting the perspective view;

means for creating a first point (445, 925) in the first coordinate system (205, 405, 905) on the interactive screen (215, 415);

means for capturing the first point (445, 925) in the second, 3D, coordinate system (210, 410, 910) as a start point (446, 926) for a curve (450, 931) being drawn in the drawing plane (408, 908), wherein the means for capturing of the first point (445, 925) as the start point (446, 926) comprises fixing the first point (445, 925) to a position that coincides with a feature (436, 920) of the drawing object which is nearest to the first point (445, 925) in the selected perspective view, wherein the feature is an edge, a surface, or a line of the drawing object, wherein the feature (436, 920) of the drawing object which is nearest to the first point being of known position in the second, 3D, coordinate system (210, 410, 910), whereby the fixing causes the coordinates of the start point (446, 926) to be determined in the second, 3D, coordinate system, and wherein the drawing plane (408, 908) is adjusted to be at the depth of the feature (436, 920) of the drawing object (220, 420, 920) which is nearest to the first point (445, 925) in the selected perspective view;

means for creating a second point (455, 935) in the first coordinate system (205, 405, 905) on the interactive screen (215, 415);

means for capturing the second point (455, 935) in the second, 3D, coordinate system (210, 410, 910) as an end point (456, 936) for the curve (450, 931), wherein the means for capturing of the second point (455, 935) as the end point (456, 936) comprises fixing the second point (455, 935) to a position that coincides with a feature (436, 920) of the drawing object (220, 420, 920) which is nearest to the second point (455, 935) in the selected perspective view, wherein the feature is an edge, a surface, or a line of the drawing object, wherein the feature (436, 920) of the drawing object which is nearest to the second point being of known position in the second, 3D, coordinate system (210, 410, 910), whereby fixing causes the coordinates of the end point (456, 936) to be determined in the second, 3D, coordinate system.

11. A drawing tool for drawing a freehand curve (450, 931), the drawing tool comprising a 2D interactive screen (215, 415) and a pointer (440) to interact with the 2D interactive screen (215, 415), and the tool for drawing a freehand curve (450, 931) on the 2D interactive screen (215, 415) in a first coordinate system (205, 405, 905), the curve (450, 931) being represented in 3D space in a second, 3D, coordinate system (210, 410, 910), with a third dimension, which requires to be determined, wherein the curve (450, 931) is drawn on a 2D drawing plane (408, 908) positioned within the second, 3D, coordinate system (210, 410, 910), and wherein the drawing plane (408, 908) lies parallel to the plane of the interactive screen (215, 415), wherein the interactive screen (215, 415) is parallel to the x-y plane of the first coordinate system (205, 405, 905),

the drawing tool further comprising:

means for selecting, for display on the interactive screen (215, 415), a perspective view of a 3D drawing object (220, 420, 920), the drawing object comprising features (220, 420, 430, 436, 920), wherein the orientation of the drawing plane (408, 908) is determined by selecting the perspective view;

means for creating a first point (445, 925) in the first coordinate system (205, 405, 905) on the interactive screen (215, 415);

means for capturing the first point (445, 925) in the second, 3D, coordinate system (210, 410, 910) as a start point (446, 926) for a curve (450, 931) being drawn in the drawing plane (408, 908), wherein the means for capturing of the first point (445, 925) as the start point (446, 926) comprises fixing the first point (445, 925) to a position that coincides with a feature (436, 920) of the drawing object which is nearest to the first point (445, 925) in the selected perspective view, wherein the feature is an edge, a surface, or a line of the drawing object, wherein the feature (436, 920) of the drawing object which is nearest to the first point being of known position in the second, 3D, coordinate system (210, 410, 910), whereby the fixing causes the coordinates of the start point (446, 926) to be determined in the second, 3D, coordinate system, and wherein the drawing plane (408, 908) is adjusted to be at the depth of the feature (436, 920) of the drawing object (220, 420, 920) which is nearest to the first point (445, 925) in the selected perspective view;

means for creating a second point (455, 935) in the first coordinate system (205, 405, 905) on the interactive screen (215, 415);

means for capturing the second point (455, 935) in the second, 3D, coordinate system (210, 410, 910) as an end point (456, 936) for the curve (450, 931), wherein the means for capturing of the second point (455, 935) as the end point (456, 936) comprises fixing the second point to the adjusted drawing plane (408, 908), whereby fixing causes the coordinates of the end point (456, 936) to be determined in the second, 3D, coordinate system.

**Patentansprüche**

1. Verfahren (300) zum Zeichnen einer Freihandkurve (450, 931) auf einem 2D-interaktiven Bildschirm (215, 415) in einem ersten Koordinatensystem (205, 405, 905), wobei ein Zeigestift (440) zum Interagieren mit dem Bildschirm (215, 415) benutzt wird, wobei die Kurve (450, 931) im 3D-Raum in einem zweiten, 3D-Koordinatensystem (210, 410, 910) mit einer dritten Dimension, die notwendigerweise zu bestimmen ist, repräsentiert wird, wobei die Kurve (450, 931) auf einer 2D-Zeichenebene (408, 908) gezeichnet wird, die innerhalb des zweiten, 3D-Koordinatensystems (210, 410, 910) positioniert ist, und wobei die Zeichenebene (408, 908) parallel zur Ebene des interaktiven Bildschirms (215, 415) liegt, wobei der interaktive Bildschirm (215, 415) parallel zur x-y-Ebene des ersten Koordinatensystems (205, 405, 905) ist, wobei das Verfahren Folgendes umfasst:

   Auswählen (305) zur Anzeige auf dem interaktiven Bildschirm (215, 415) einer perspektivischen Ansicht eines 3D-Zeichenobjekts (220, 420, 920), wobei das Zeichenobjekt Merkmale (220, 420, 430, 436, 920) umfasst, wobei die Ausrichtung der Zeichenebene (408, 908) durch das Auswählen der perspektivischen Ansicht bestimmt ist;
   Erzeugen (310) eines ersten Punktes (445, 925) im ersten Koordinatensystem (205, 405, 905) auf dem interaktiven Bildschirm (215, 415);
   Erfassen (310, 325, 330) des ersten Punktes (445, 925) im zweiten, 3D-Koordinatensystem (210, 410, 910) als einen Startpunkt (446, 926) für eine Kurve (450, 931), die in der Zeichenebene (408, 908) gezeichnet wird, wobei das Erfassen des ersten Punktes (445, 925) als den Startpunkt (446, 926) umfasst, den ersten Punkt (445, 925) auf eine Position festzulegen, die mit einem Merkmal (436, 920) des Zeichenobjekts zusammenfällt, das zum ersten Punkt (445, 925) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum ersten Punkt am nächsten gelegen ist, eine bekannte Position im zweiten, 3D-Koordinatensystem (210, 410, 910) hat, wodurch das Festlegen dafür sorgt, dass die Koordinaten des Startpunktes (446, 926) im zweiten, 3D-Koordinatensystem bestimmt sind, und wobei die Zeichenebene (408, 908) adjustiert ist, an der Tiefe des Merkmals (436, 920) des Zeichenobjekts (220, 420, 920) zu liegen, das zum ersten Punkt (445, 925) in der ausgewählten perspektivischen Ansicht am nächsten gelegen ist;
   Erzeugen (320) eines zweiten Punktes (455, 935) im ersten Koordinatensystem (205, 405, 905) auf dem interaktiven Bildschirm (215, 415);
   Erfassen (320, 335, 340) des zweiten Punktes (455, 935) im zweiten, 3D-Koordinatensystem (210, 410, 910) als einen Endpunkt (456, 936) für die Kurve (450, 931), wobei das Erfassen des zweiten Punktes (455, 935) als den Endpunkt (456, 936) umfasst, den zweiten Punkt (455, 935) auf eine Position festzulegen, die mit einem Merkmal (436, 920) des Zeichenobjekts (220, 420, 920) zusammenfällt, das zum zweiten Punkt (455, 935) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum zweiten Punkt am nächsten gelegen ist, eine bekannte Position im zweiten, 3D-Koordinatensystem (210, 410, 910) hat, wodurch das Festlegen dafür sorgt, dass die Koordinaten des Endpunktes (456, 936) im zweiten, 3D-Koordinatensystem bestimmt sind.

2. Verfahren (300) zum Zeichnen einer Freihandkurve (450, 931) auf einem 2D-interaktiven Bildschirm (215, 415) in einem ersten Koordinatensystem (205, 405, 905), wobei ein Zeigestift (440) zum Interagieren mit dem Bildschirm (215, 415) benutzt wird, wobei die Kurve (450, 931) im 3D-Raum in einem zweiten, 3D-Koordinatensystem (210, 410, 910) mit einer dritten Dimension, die notwendigerweise zu bestimmen ist, repräsentiert wird, wobei die Kurve (450, 931) auf einer 2D-Zeichenebene (408, 908) gezeichnet wird, die innerhalb des zweiten, 3D-Koordinatensystems (210, 410, 910) positioniert ist, und wobei die Zeichenebene (408, 908) parallel zur Ebene des interaktiven Bildschirms (215, 415) liegt, wobei der interaktive Bildschirm (215, 415) parallel zur x-y-Ebene des ersten Koordinatensystems (205, 405, 905) ist, wobei das Verfahren Folgendes umfasst:

   Auswählen (305) zur Anzeige auf dem interaktiven Bildschirm (215, 415) einer perspektivischen Ansicht eines 3D-Zeichenobjekts (220, 420, 920), wobei das Zeichenobjekt Merkmale (220, 420, 430, 436, 920) umfasst, wobei die Ausrichtung der Zeichenebene (408, 908) durch das Auswählen der perspektivischen Ansicht bestimmt ist;
   Erzeugen (310) eines ersten Punktes (445, 925) im ersten Koordinatensystem (205, 405, 905) auf dem interaktiven Bildschirm (215, 415);
   Erfassen (310, 325, 330) des ersten Punktes (445, 925) im zweiten, 3D-Koordinatensystem (210, 410, 910) als einen Startpunkt (446, 926) für eine Kurve (450, 931), die in der Zeichenebene (408, 908) gezeichnet wird,

wobei das Erfassen des ersten Punktes (445, 925) als den Startpunkt (446, 926) umfasst, den ersten Punkt (445, 925) auf eine Position festzulegen, die mit einem Merkmal (436, 920) des Zeichenobjekts zusammenfällt, das zum ersten Punkt (445, 925) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum ersten Punkt am nächsten gelegen ist, eine bekannte Position im zweiten, 3D-Koordinatensystem (210, 410, 910) hat, wodurch das Festlegen dafür sorgt, dass die Koordinaten des Startpunktes (446, 926) im zweiten, 3D-Koordinatensystem bestimmt sind, und wobei die Zeichenebene (408, 908) adjustiert ist, an der Tiefe des Merkmals (436, 920) des Zeichenobjekts (220, 420, 920) zu liegen, das zum ersten Punkt (445, 925) in der ausgewählten perspektivischen Ansicht am nächsten gelegen ist;

Erzeugen (320) eines zweiten Punktes (455, 935) im ersten Koordinatensystem (205, 405, 905) auf dem interaktiven Bildschirm (215, 415);
Erfassen (320, 335, 340) des zweiten Punktes (455, 935) im zweiten, 3D-Koordinatensystem (210, 410, 910) als einen Endpunkt (456, 936) für die Kurve (450, 931), wobei das Erfassen des zweiten Punktes (455, 935) als den Endpunkt (456, 936) umfasst, den zweiten Punkt (455, 935) auf die adjustierte Zeichenebene (408, 908) festzulegen, wodurch das Festlegen dafür sorgt, dass die Koordinaten des Endpunktes (456, 936) im zweiten, 3D-Koordinatensystem bestimmt sind.

3. Verfahren nach Anspruch 1 oder 2, wobei die Zeichenebene ein Gitter ist, das Quadrate umfasst, die in ihrer Größe angepasst sind, um die Tiefe der Zeichenebene anzuzeigen.

4. Verfahren nach einem der vorangehenden Ansprüche, wobei der Zeigestift ein Eingabestift mit einer vorgegebenen Auflösung ist.

5. Verfahren nach Anspruch 4, wobei das Festlegen eine Anpassung von x und y im ersten Koordinatensystem umfasst, wobei die Anpassung geringer als die Auflösung des Eingabestiftes multipliziert mit einem Faktor ist.

6. Verfahren nach Anspruch 5, wobei der Faktor ein Wert zwischen zwei und vier ist.

7. Verfahren nach einem der vorangehenden Ansprüche, ferner umfassend:
Ziehen des Zeigestiftes vom ersten Punkt zum zweiten Punkt über den interaktiven Bildschirm, um die Kurve zu formen.

8. Verfahren nach Anspruch 7, wobei der erste Punkt durch Aufsetzen des Eingabestiftes auf die Oberfläche des interaktiven Bildschirms erzeugt wird, der zweite Punkt durch Abheben des Eingabestiftes von der Oberfläche des interaktiven Bildschirms erzeugt wird.

9. Verfahren nach einem der vorangehenden Ansprüche, wobei die Kurve in einer Ebene liegt, die von einem Vektor zwischen dem Startpunkt und dem Endpunkt im zweiten, 3D-Koordinatensystem und einer Linie, die senkrecht zum Vektor liegt und die parallel zur Ebene des Bildschirms ist, in der die Kurve gezeichnet wurde, definiert wird.

10. Zeichenwerkzeug zum Zeichnen einer Freihandkurve (450, 931), wobei das Zeichenwerkzeug einen 2D-interaktiven Bildschirm (215, 415) und einen Zeigestift (440) zum Interagieren mit dem 2D-interaktiven Bildschirm (215, 415) und das Werkzeug zum Zeichnen einer Freihandkurve (450, 931) auf dem 2D-interaktiven Bildschirm (215, 415) in einem ersten Koordinatensystem (205, 405, 905) umfasst, wobei die Kurve (450, 931) im 3D-Raum in einem zweiten, 3D-Koordinatensystem (210, 410, 910) mit einer dritten Dimension, die notwendigerweise zu bestimmen ist, repräsentiert wird, wobei die Kurve (450, 931) auf einer 2D-Zeichenebene (408, 908) gezeichnet wird, die innerhalb des zweiten, 3D-Koordinatensystems (210, 410, 910) positioniert ist, und wobei die Zeichenebene (408, 908) parallel zur Ebene des interaktiven Bildschirms (215, 415) liegt, wobei der interaktive Bildschirm (215, 415) parallel zur x-y-Ebene des ersten Koordinatensystems (205, 405, 905) ist, wobei das Zeichenwerkzeug ferner Folgendes umfasst:

Mittel zum Auswählen, zur Anzeige auf dem interaktiven Bildschirm (215, 415), einer perspektivischen Ansicht eines 3D-Zeichenobjekts (220, 420, 920), wobei das Zeichenobjekt Merkmale (220, 420, 430, 436, 920) umfasst, wobei die Ausrichtung der Zeichenebene (408, 908) durch das Auswählen der perspektivischen Ansicht bestimmt ist;
Mittel zum Erzeugen eines ersten Punktes (445, 925) im ersten Koordinatensystem (205, 405, 905) auf dem interaktiven Bildschirm (215, 415);
Mittel zum Erfassen des ersten Punktes (445, 925) im zweiten, 3D-Koordinatensystem (210, 410, 910) als einen Startpunkt (446, 926) für eine Kurve (450, 931), die in der Zeichenebene (408, 908) gezeichnet wird, wobei die Mittel zum Erfassen des ersten Punktes (445, 925) als den Startpunkt (446, 926) umfassen, den ersten Punkt (445, 925) auf eine Position festzulegen, die mit einem Merkmal (436, 920) des Zeichenobjekts zusammenfällt, das zum ersten Punkt (445, 925) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum ersten Punkt am nächsten gelegen ist, eine bekannte Position im zweiten, 3D-Koordinatensystem (210, 410, 910) hat, wodurch das Festlegen dafür sorgt, dass die Koordinaten des Startpunktes (446, 926) im zweiten, 3D-Koordinatensystem bestimmt sind, und wobei die Zeichenebene (408, 908) adjustiert ist, an der Tiefe des Merkmals (436, 920) des Zeichenobjekts (220, 420, 920) zu liegen, das zum ersten Punkt (445, 925) in der ausgewählten perspektivischen Ansicht am nächsten gelegen ist;
Mittel zum Erzeugen eines zweiten Punktes (455, 935) im ersten Koordinatensystem (205, 405, 905) auf dem interaktiven Bildschirm (215, 415);
Mittel zum Erfassen des zweiten Punktes (455, 935) im zweiten, 3D-Koordinatensystem (210, 410, 910) als einen Endpunkt (456, 936) für die Kurve (450, 931), wobei die Mittel zum Erfassen des zweiten Punktes (455, 935) als den Endpunkt (456, 936) umfassen, den zweiten Punkt (455, 935) auf eine Position festzulegen, die mit einem Merkmal (436, 920) des Zeichenobjekts (220, 420, 920) zusammenfällt, das zum zweiten Punkt (455, 935) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum zweiten Punkt am nächsten gelegen ist, eine bekannte Position im zweiten, 3D-Koordinatensystem (210, 410, 910) hat, wodurch das Festlegen dafür sorgt, dass die Koordinaten des Endpunktes (456, 936) im zweiten, 3D-Koordinatensystem bestimmt sind.

11. Zeichenwerkzeug zum Zeichnen einer Freihandkurve (450, 931), wobei das Zeichenwerkzeug einen 2D-interaktiven Bildschirm (215, 415) und einen Zeigestift (440) zum Interagieren mit dem 2D-interaktiven Bildschirm (215, 415) und das Werkzeug zum Zeichnen einer Freihandkurve (450, 931) auf dem 2D-interaktiven Bildschirm (215, 415) in einem ersten Koordinatensystem (205, 405, 905) umfasst, wobei die Kurve (450, 931) im 3D-Raum in einem zweiten, 3D-Koordinatensystem (210, 410, 910) mit einer dritten Dimension, die notwendigerweise zu bestimmen ist, repräsentiert wird, wobei die Kurve (450, 931) auf einer 2D-Zeichenebene (408, 908) gezeichnet wird, die innerhalb des zweiten, 3D-Koordinatensystems (210, 410, 910) positioniert ist, und wobei die Zeichenebene (408, 908) parallel zur Ebene des interaktiven Bildschirms (215, 415) liegt, wobei der interaktive Bildschirm (215, 415) parallel zur x-y-Ebene des ersten Koordinatensystems (205, 405, 905) ist, wobei das Zeichenwerkzeug ferner Folgendes umfasst:

Mittel zum Auswählen, zur Anzeige auf dem interaktiven Bildschirm (215, 415), einer perspektivischen Ansicht eines 3D-Zeichenobjekts (220, 420, 920), wobei das Zeichenobjekt Merkmale (220, 420, 430, 436, 920) umfasst, wobei die Ausrichtung der Zeichenebene (408, 908) durch das Auswählen der perspektivischen Ansicht bestimmt ist;
Mittel zum Erzeugen eines ersten Punktes (445, 925) im ersten Koordinatensystem (205, 405, 905) auf dem interaktiven Bildschirm (215, 415);
Mittel zum Erfassen des ersten Punktes (445, 925) im zweiten, 3D-Koordinatensystem (210, 410, 910) als einen Startpunkt (446, 926) für eine Kurve (450, 931), die in der Zeichenebene (408, 908) gezeichnet wird, wobei die Mittel zum Erfassen des ersten Punktes (445, 925) als den Startpunkt (446, 926) umfassen, den ersten Punkt (445, 925) auf eine Position festzulegen, die mit einem Merkmal (436, 920) des Zeichenobjekts zusammenfällt, das zum ersten Punkt (445, 925) in der ausgewählten perspektivischen Ansicht am nächsten gelegen ist, wobei das Merkmal eine Kante, eine Oberfläche oder eine Linie des Zeichenobjekts ist, wobei das Merkmal (436, 920) des Zeichenobjekts, welches zum ersten Punkt am nächsten gelegen ist, eine bekannte Position im zweiten, 3D-Koordinatensystem (210, 410, 910) hat, wodurch das Festlegen dafür sorgt, dass die Koordinaten des Startpunktes (446, 926) im zweiten, 3D-Koordinatensystem bestimmt sind, und wobei die Zeichenebene (408, 908) adjustiert ist, an der Tiefe des Merkmals (436, 920) des Zeichenobjekts (220, 420, 920) zu liegen, das zum ersten Punkt (445, 925) in der ausgewählten perspektivischen Ansicht am nächsten gelegen ist;
Mittel zum Erzeugen eines zweiten Punktes (455, 935) im ersten Koordinatensystem (205, 405, 905) auf dem interaktiven Bildschirm (215, 415);
Mittel zum Erfassen des zweiten Punktes (455, 935) im zweiten, 3D-Koordinatensystem (210, 410, 910) als einen Endpunkt (456, 936) für die Kurve (450, 931), wobei die Mittel zum Erfassen des zweiten Punktes (455, 935) als den Endpunkt (456, 936) umfassen, den zweiten Punkt auf die adjustierte Zeichenebene (408, 908) festzulegen, wodurch das Festlegen dafür sorgt, dass die Koordinaten des Endpunktes (456, 936) im zweiten, 3D-Koordinatensystem bestimmt sind.

**Revendications**

1. Un procédé (300) de tracé d'une courbe à main levée (450, 931) sur un écran interactif 2D (215, 415) dans un premier système de coordonnées (205, 405, 905), où un pointeur (440) est utilisé de façon à interagir avec l'écran (215, 415), la courbe (450, 931) étant représentée dans un espace 3D dans un deuxième système de coordonnées, 3D, (210, 410, 910), avec une troisième dimension, qui exige d'être déterminée, où la courbe (450, 931) est tracée sur un plan de tracé 2D (408, 908) positionné à l'intérieur du deuxième système de coordonnées, 3D, (210, 410, 910), et où le plan de tracé (408, 908) est parallèle au plan de l'écran interactif (215, 415), où l'écran interactif (215, 415) est parallèle au plan x-y du premier système de coordonnées (205, 405, 905), le procédé comprenant :

   la sélection (305), pour un affichage sur l'écran interactif (215, 415), d'une vue en perspective d'un objet de tracé 3D (220, 420, 920), l'objet de tracé comprenant des caractéristiques (220, 420, 430, 436, 920), où l'orientation du plan de tracé (408, 908) est déterminée par la sélection de la vue en perspective,
   la création (310) d'un premier point (445, 925) dans le premier système de coordonnées (205, 405, 905) sur l'écran interactif (215, 415),
   la capture (310, 325, 330) du premier point (445, 925) dans le deuxième système de coordonnées, 3D, (210, 410, 910) en tant que point de départ (446, 926) pour une courbe (450, 931) qui est tracée dans le plan de tracé (408, 908), où la capture du premier point (445, 925) en tant que point de départ (446, 926) comprend la fixation du premier point (445, 925) sur une position qui coïncide avec une caractéristique (436, 920) de l'objet de tracé qui est la plus proche du premier point (445, 925) dans la vue en perspective sélectionnée, où la caractéristique est un bord, une surface ou une ligne de l'objet de tracé, où la caractéristique (436, 920) de l'objet de tracé qui est la plus proche du premier point est d'une position connue dans le deuxième système de coordonnées, 3D, (210, 410, 910), grâce à quoi la fixation amène les coordonnées du point de départ (446, 926) à être déterminées dans le deuxième système de coordonnées, 3D, et où le plan de tracé (408, 908) est ajusté de façon à être à la profondeur de la caractéristique (436, 920) de l'objet de tracé (220, 420, 920) qui est la plus proche du premier point (445, 925) dans la vue en perspective sélectionnée,
   la création (320) d'un deuxième point (455, 935) dans le premier système de coordonnées (205, 405, 905) sur l'écran interactif (215, 415),
   la capture (320, 335, 340) du deuxième point (455, 935) dans le deuxième système de coordonnées, 3D, (210, 410, 910) en tant que point de fin (456, 936) pour la courbe (450, 931), où la capture du deuxième point (455, 935) en tant que point de fin (456, 936) comprend la fixation du deuxième point (455, 935) sur une position qui coïncide avec une caractéristique (436, 920) de l'objet de tracé (220, 420, 920) qui est la plus proche du deuxième point (455, 935) dans la vue en perspective sélectionnée, où la caractéristique est un bord, une surface ou une ligne de l'objet de tracé, où la caractéristique (436, 920) de l'objet de tracé qui est la plus proche du deuxième point est d'une position connue dans le deuxième système de coordonnées, 3D, (210, 410, 910), grâce à quoi la fixation amène les coordonnées du point de fin (456, 936) à être déterminées dans le deuxième système de coordonnées, 3D.

2. Un procédé (300) de tracé d'une courbe à main levée (450, 931) sur un écran interactif 2D (215, 415) dans un premier système de coordonnées (205, 405, 905), où un pointeur (440) est utilisé de façon à interagir avec l'écran (215, 415), la courbe (450, 931) étant représentée dans un espace 3D dans un deuxième système de coordonnées, 3D, (210, 410, 910), avec une troisième dimension, qui exige d'être déterminée, où la courbe (450, 931) est tracée sur un plan de tracé 2D (408, 908) positionné à l'intérieur du deuxième système de coordonnées, 3D, (210, 410, 910), et où le plan de tracé (408, 908) est parallèle au plan de l'écran interactif (215, 415), où l'écran interactif (215, 415) est parallèle au plan x-y du premier système de coordonnées (205, 405, 905), le procédé comprenant :

   la sélection (305), pour un affichage sur l'écran interactif (215, 415), d'une vue en perspective d'un objet de tracé 3D (220, 420, 920), l'objet de tracé comprenant des caractéristiques (220, 420, 430, 436, 920), où l'orientation du plan de tracé (408, 908) est déterminée par la sélection de la vue en perspective,
   la création (310) d'un premier point (445, 925) dans le premier système de coordonnées (205, 405, 905) sur l'écran interactif (215, 415),
   la capture (310, 325, 330) du premier point (445, 925) dans le deuxième système de coordonnées, 3D, (210, 410, 910) en tant que point de départ (446, 926) pour une courbe (450, 931) qui est tracée dans le plan de tracé (408, 908), où la capture du premier point (445, 925) en tant que point de départ (446, 926) comprend la fixation du premier point (445, 925) sur une position qui coïncide avec une caractéristique (436, 920) de l'objet de tracé qui est la plus proche du premier point (445, 925) dans la vue en perspective sélectionnée, où la caractéristique est un bord, une surface ou une ligne de l'objet de tracé, où la caractéristique (436, 920) de l'objet de tracé qui est la plus proche du premier point est d'une position connue dans le deuxième système de coordonnées, 3D, (210, 410, 910), grâce à quoi la fixation amène les coordonnées du point de départ (446, 926) à être déterminées dans le deuxième système de coordonnées, 3D, et où le plan de tracé (408, 908) est ajusté de façon à être à la profondeur de la caractéristique (436, 920) de l'objet de tracé (220, 420, 920) qui est la plus proche du premier point (445, 925) dans la vue en perspective sélectionnée,

la création (320) d'un deuxième point (455, 935) dans le premier système de coordonnées (205, 405, 905) sur l'écran interactif (215, 415),

la capture (320, 335, 340) du deuxième point (455, 935) dans le deuxième système de coordonnées, 3D, (210, 410, 910) en tant que point de fin (456, 936) pour la courbe (450, 931), où la capture du deuxième point (455, 935) en tant que point de fin (456, 936) comprend la fixation du deuxième point (455, 935) sur le plan de tracé ajusté (408, 908), grâce à quoi la fixation amène les coordonnées du point de fin (456, 936) à être déterminées dans le deuxième système de coordonnées, 3D.

3. Le procédé selon la Revendication 1 ou 2, où le plan de tracé est une grille comprenant des carrés qui s'ajustent en taille de façon à indiquer la profondeur du plan de tracé.

4. Le procédé selon l'une quelconque des Revendications précédentes, où le pointeur est un stylet possédant une résolution définie.

5. Le procédé selon la Revendication 4, où la fixation comprend un ajustement x et y dans le premier système de coordonnées, l'ajustement étant inférieur à la résolution du stylet multipliée par un facteur.

6. Le procédé selon la Revendication 5, où le facteur est une valeur entre deux et quatre.

7. Le procédé selon l'une quelconque des Revendications précédentes, comprenant en outre :
le glissement du pointeur, du premier point vers le deuxième point, sur l'écran interactif de façon à former la courbe.

8. Le procédé selon la Revendication 7, où le premier point est créé par le placement du stylet sur la surface de l'écran interactif, le deuxième point est créé par le soulèvement du stylet à partir de la surface de l'écran interactif.

9. Le procédé selon l'une quelconque des Revendications précédentes, où la courbe se situe dans un plan défini par un vecteur entre le point de départ et le point de fin dans le deuxième système de coordonnées, 3D, et une ligne perpendiculaire au vecteur qui est parallèle au plan de l'écran dans lequel la courbe a été tracée.

10. Un outil de tracé destiné au tracé d'une courbe à main levée (450, 931), l'outil de tracé comprenant un écran interactif 2D (215, 415) et un pointeur (440) destiné à interagir avec l'écran interactif 2D (215, 415), et l'outil de tracé d'une courbe à main levée (450, 931) sur l'écran interactif 2D (215, 415) dans un premier système de coordonnées (205, 405, 905), la courbe (450, 931) étant représentée dans un espace 3D dans un deuxième système de coordonnées, 3D, (210, 410, 910), avec une troisième dimension, qui exige d'être déterminée, où la courbe (450, 931) est tracée sur un plan de tracé 2D (408, 908) positionné à l'intérieur du deuxième système de coordonnées, 3D, (210, 410, 910), et où le plan de tracé (408, 908) est parallèle au plan de l'écran interactif (215, 415), où l'écran interactif (215, 415) est parallèle au plan x-y du premier système de coordonnées (205, 405, 905), l'outil de tracé comprenant en outre :

un moyen de sélection, pour un affichage sur l'écran interactif (215, 415), d'une vue en perspective d'un objet de tracé 3D (220, 420, 920), l'objet de tracé comprenant des caractéristiques (220, 420, 430, 436, 920), où l'orientation du plan de tracé (408, 908) est déterminée par la sélection de la vue en perspective,

un moyen de création d'un premier point (445, 925) dans le premier système de coordonnées (205, 405, 905) sur l'écran interactif (215, 415),

un moyen de capture du premier point (445, 925) dans le deuxième système de coordonnées, 3D, (210, 410, 910) en tant que point de départ (446, 926) pour une courbe (450, 931) qui est tracée dans le plan de tracé (408, 908), où le moyen de capture du premier point (445, 925) en tant que point de départ (446, 926) comprend la fixation du premier point (445, 925) sur une position qui coïncide avec une caractéristique (436, 920) de l'objet de tracé qui est la plus proche du premier point (445, 925) dans la vue en perspective sélectionnée, où la caractéristique est un bord, une surface ou une ligne de l'objet de tracé, où la caractéristique (436, 920) de l'objet de tracé qui est la plus proche du premier point est d'une position connue dans le deuxième système de coordonnées, 3D, (210, 410, 910), grâce à quoi la fixation amène les coordonnées du point de départ (446, 926) à être déterminées dans le deuxième système de coordonnées, 3D, et où le plan de tracé (408, 908) est ajusté de façon à être à la profondeur de la caractéristique (436, 920) de l'objet de tracé (220, 420, 920) qui est la plus proche du premier point (445, 925) dans la vue en perspective sélectionnée,

un moyen de création d'un deuxième point (455, 935) dans le premier système de coordonnées (205, 405, 905) sur l'écran interactif (215, 415),

un moyen de capture du deuxième point (455, 935) dans le deuxième système de coordonnées, 3D, (210, 410, 910) en tant que point de fin (456, 936) pour la courbe (450, 931), où le moyen de capture du deuxième point (455, 935) en tant que point de fin (456, 936) comprend la fixation du deuxième point (455, 935) sur une position qui coïncide avec une caractéristique (436, 920) de l'objet de tracé (220, 420, 920) qui est la plus proche du deuxième point (455, 935) dans la vue en perspective sélectionnée, où la caractéristique est un bord, une surface ou une ligne de l'objet de tracé, où la caractéristique (436, 920) de l'objet de tracé qui est la plus proche du deuxième point est d'une position connue dans le deuxième système de coordonnées, 3D, (210, 410, 910), grâce à quoi la fixation amène les coordonnées du point de fin (456, 936) à être déterminées dans le deuxième système de coordonnées, 3D.

11. Un outil de tracé destiné au tracé d'une courbe à main levée (450, 931), l'outil de tracé comprenant un écran interactif 2D (215, 415) et un pointeur (440) destiné à interagir avec l'écran interactif 2D (215, 415) et l'outil de tracé d'une courbe à main levée (450, 931) sur l'écran interactif 2D (215, 415) dans un premier système de coordonnées (205, 405, 905), la courbe (450, 931) étant représentée dans un espace 3D dans un deuxième système de coordonnées, 3D, (210, 410, 910), avec une troisième dimension, qui exige d'être déterminée, où la courbe (450, 931) est tracée sur un plan de tracé 2D (408, 908) positionné à l'intérieur du deuxième système de coordonnées, 3D, (210, 410, 910), et où le plan de tracé (408, 908) est parallèle au plan de l'écran interactif (215, 415), où l'écran interactif (215, 415) est parallèle au plan x-y du premier système de coordonnées (205, 405, 905), l'outil de tracé comprenant en outre :

un moyen de sélection, pour un affichage sur l'écran interactif (215, 415), d'une vue en perspective d'un objet de tracé 3D (220, 420, 920), l'objet de tracé comprenant des caractéristiques (220, 420, 430, 436, 920), où l'orientation du plan de tracé (408, 908) est déterminée par la sélection de la vue en perspective,

un moyen de création d'un premier point (445, 925) dans le premier système de coordonnées (205, 405, 905) sur l'écran interactif (215, 415),

un moyen de capture du premier point (445, 925) dans le deuxième système de coordonnées, 3D, (210, 410, 910) en tant que point de départ (446, 926) pour une courbe (450, 931) qui est tracée dans le plan de tracé (408, 908), où le moyen de capture du premier point (445, 925) en tant que point de départ (446, 926) comprend la fixation du premier point (445, 925) sur une position qui coïncide avec une caractéristique (436, 920) de l'objet de tracé qui est la plus proche du premier point (445, 925) dans la vue en perspective sélectionnée, où la caractéristique est un bord, une surface ou une ligne de l'objet de tracé, où la caractéristique (436, 920) de l'objet de tracé qui est la plus proche du premier point est d'une position connue dans le deuxième système de coordonnées, 3D, (210, 410, 910), grâce à quoi la fixation amène les coordonnées du point de départ (446, 926) à être déterminées dans le deuxième système de coordonnées, 3D, et où le plan de tracé (408, 908) est ajusté de façon à être à la profondeur de la caractéristique (436, 920) de l'objet de tracé (220, 420, 920) qui est la plus proche du premier point (445, 925) dans la vue en perspective sélectionnée,

un moyen de création d'un deuxième point (455, 935) dans le premier système de coordonnées (205, 405, 905) sur l'écran interactif (215, 415),

un moyen de capture du deuxième point (455, 935) dans le deuxième système de coordonnées, 3D, (210, 410, 910) en tant que point de fin (456, 936) pour la courbe (450, 931), où le moyen de capture du deuxième point (455, 935) en tant que point de fin (456, 936) comprend la fixation du deuxième point sur le plan de tracé ajusté (408, 908), grâce à quoi la fixation amène les coordonnées du point de fin (456, 936) à être déterminées dans le deuxième système de coordonnées, 3D.

Fig. 1A Prior Art

Fig. 1B Prior Art

Fig. 2

| 305 | Select perspective view |
| 300 |

| 310 | Place stylus at a first point, drawing plane adjusted |

| 315 | Start drawing curve from a first point |

| 320 | End drawing curve at a second point |

| 325 | Determine, in the 2D projection of the 3D object, the nearest feature to the first point |

| 330 | Fix the first point to the 3D location of the determined nearest feature |

| 335 | Determine, in the 2D projection of the 3D object, the nearest feature to the second point |

| 340 | Fix the second point to the 3D location of the determined nearest feature |

Fig. 3

FIG. 4

EP 3 931 675 B1

FIG. 5

FIG. 6

EP 3 931 675 B1

FIG. 7

FIG. 8

Fig. 9B

Fig. 9A

Fig. 10

Fig. 11

Fig. 12

EP 3 931 675 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012206419 A1, LEE JINHA
- EP 0686281 A1
- US 9147282 B1, COTE STEPHANE
- WO 2018075054 A1
- EP 2018083618 W